# EUROPEAN PATENT APPLICATION

(11) **EP 1 115 148 A1**
(43) Date of publication of application: **11.07.2001**
(21) Application number: 99933217.4
(22) Date of filing: 02.08.1999
(51) Int. Cl.: H01L 21/316, H01L 21/31, H01L 27/108

(54) **VAPOR GROWTH METHOD FOR METAL OXIDE DIELECTRIC FILM AND VAPOR GROWTH DEVICE FOR METAL OXIDE DIELECTRIC MATERIAL**

(30) Priority: 03.08.1998 JP 21918398; 03.08.1998 JP 21918498; 03.08.1998 JP 21918798
(71) Applicant: NEC Corporation, Minato-ku, Tokyo 108-8001 (JP)
(72) Inventor: TATSUMI, Toru, Tokyo 108-8001 (JP); YAMASHITA, Atsushi, Tokyo 108-8001 (JP)
(74) Representative: Betten & Resch
(86) International application number: JP9904145
(87) International publication number: WO0008680

(57) **Abstract**

The present invention relates to a vapor phase growth method of a metal oxide dielectric film and capable of forming a metal oxide with excellent in both orientation and crystallinity on a plug at a low temperature and carries out film formation by introducing the organometal gases and an oxidizing gas into a vacuum chamber through separate introduction inlets while heating the substrate set in the vacuum chamber at 1 × 10⁻² Torr or lower of the total pressure of the vacuum chamber. Further, the present invention is for carrying out film formation of a metal oxide dielectric film with a perovskite type crystal structure by changing film formation conditions and properly selecting optimum conditions for first film formation conditions for initial nuclei or layer formation and second film formation conditions for film formation of the perovskite type crystal structure further on the formed initial nuclei. The present invention further relates to a vapor phase growth apparatus to be employed for the vapor phase growth methods.

## Description

### TECHNICAL FIELD

The present invention relates to a fabrication method and a fabrication apparatus of a semiconductor device having capacitor elements, more specifically, the present invention relates to a vapor phase growth method and a vapor phase growth apparatus to be employed in the case of carrying out vapor phase growth of a metal oxide type high-dielectric-constant film, a metal oxide ferroelectric film, and further a metal oxide dielectric film with a perovskite type crystal structure generally represented by ABO₃ to be used for a capacitor and a gate of a semiconductor integrated circuit using raw materials of organometal gases.

### BACKGROUND ART

In recent years, ferroelectric memories using ferroelectric capacitors, dynamic random access memories (DRAMS) using high-dielectric-constant capacitors, and the likes have actively been investigated and developed. These ferroelectric memories and DRAMs comprise selective transistors and store information using capacitors, as memory cells, connected to one diffusion layer of each selective transistor. The ferroelectric capacitors are provided with, as a capacitive insulating film, a ferroelectric film such as Pb(Zr, Ti)O₃ (hereafter referred to as PZT) or the like and enabled to store non-volatile information by polarizing the ferroelectric film. Meanwhile, the high-dielectric-constant capacitors are provided with, as a capacitive insulating film, a high-dielectric-constant thin film of (Ba, Sr)TiO₃ (hereafter referred to as BST), so that the capacitors have high capacitance and enable elements to be miniaturized in a fine structure.

In the case of using such ceramic materials for semiconductor elements, it is highly important to deposit such ceramic materials in a thin film with excellent crystallinity on a conductive film to be a lower electrode. As the method for depositing a thin film, there have conventionally been reported a sol-gel method, a sputtering method, and a CVD method.

The sol-gel method is a method in which organometal materials dissolved in an organic solvent are applied to a wafer having a lower electrode formed thereon, by a spin coating, and crystallized by annealing in oxygen. In the method, since crystallization takes place in a solid phase, the temperature for the crystallization is necessary to be very high and in the case of using PZT for a metal oxide dielectric film, the crystallization temperature required to aquifer sufficient ferroelectric properties is 600°C and in the case of BST, the crystallization temperature required to acquire sufficiently high dielectric properties is 650°C. A crystal formed by the foregoing method has a defect that the orientation of the crystal is uneven. Further, the sol-gel method is difficult to be applied to a wafer with a large diameter and furthermore', the method is inferior in coating of stepped surfaces and thus unsuitable for high integration of a device.

The sputtering method is a method in which a film is formed on a wafer having electrodes thereon, by reactive sputtering of a ceramic sintered body to be formed into the film using Ar + O₂ plasma and then subjected to crystallization by annealing in oxygen. The film can be made even by making the diameter of the target wide and a sufficiently high film formation speed can be obtained by increasing the power for plasma generation. However, in the sputtering method as well, the crystallization is required to be carried out at a high temperature and in the case of using PZT for a metal oxide dielectric film, the crystallization temperature required to acquire sufficient ferroelectric properties is 600°C and in the case of BST, the crystallization temperature required to acquire sufficiently high dielectric properties is 650°C. Further, in the sputtering method, since the composition of the film obtained is substantially determined by the composition of the target used, the target has to be replaced in order to change the composition and that is disadvantageous from a viewpoint of production process.

The CVD method is a method in which raw materials are transferred in gaseous state to a vacuum chamber to form a film. It is considered that the CVD method is excellent in uniform film formation on a wafer with a large diameter and in coating property on stepped surfaces and highly expected as a technique for mass production in the case of application to ULSI. The metals of constituent elements of a metal oxide dielectric film are Ba, Sr, Bi, Pb, Ti, Zr, Ta, La, and the likes and since proper hydrides and chlorides of these metals are very few, organometals are used for vapor phase growth. However, these organometals have low vapor-pressures and are mostly solids or liquid at a room temperature and, therefore, a transferring method using a carrier gas is employed.

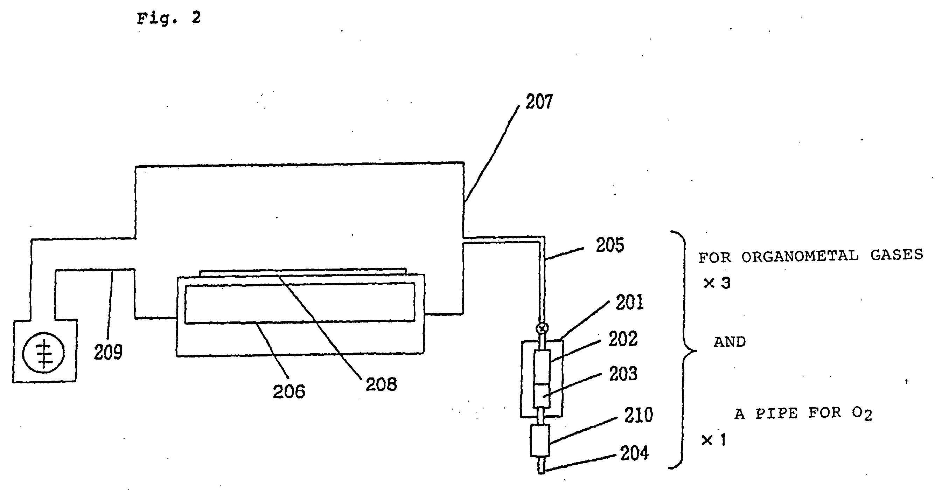

Fig. 2 is a diagrammatic illustration illustrating the reaction gas supply method in the case of using a carrier gas. The apparatus is composed of a thermostatic tank 201, a bottle 202, organometal raw materials 203 made ready in the bottle, a supply pipe 204 for an inert carrier gas such as Ar, N₂, and the likes, a mass flow controller 210 for the carrier gas, a supply pipe 205 for organometal gases to be transferred by the carrier gas, a growth chamber 207 equipped with a heating mechanism 206, a gas discharge port 209, and so forth.

The organometal materials 203 made ready in the bottle are, for example, strontium bis(dipivaloylmethanate) {abbr. Sr(DPM)₂}, barium bis(dipivaloylmethanate) {abbr. Ba(DPM)₂}, and lead bis(dipivaloylmethanate) {abbr. Pb(DPM)₂}, and maintain solid or liquid state at a normal temperature. In the CVD method using the apparatus, these organometal materials are sublimated in the bottle 202 and supplied to the growth chamber 207 while being accompanied with a carrier gas supplied from the supply pipe 204 to form a film on a heated wafer 208. The pressure during the film formation at that time is the atmospheric pressure or a pressure of several Torr.

In the case such a method is employed, however, there is a disadvantageous point that the organometal gas flow rates in the carrier gas are difficult to be quantified and precisely controlled. That is because the carrier gas contains organometal gases in an amount equal to or more than the amount corresponding to the saturated vapor pressure determined by the temperature of the thermostatic tank 202 and because the flow rates of the organometal gases depend not only on the flow rate of the carrier gas but also on the surface area of raw material solids and the temperature of the thermostatic tank. According to the description of Jpn. J. Appl. Phys. Vol. 32 (1993) P. 4175 on the formation of a film of PTO (lead titanate: PbTiO₃) by the above film formation method, the temperature of the formation of a PTO film is very high, as high as 570°C, and the film obtained has a drawback point that crystal orientation is uneven.

Description regarding a method for forming a thin film by supplying reactive molecules to a substrate in a decreased pressure is given in Japanese Patent Laid-Open No. 5-251355. The film formation method described in the publication of the patent aims to improve the gas utilization efficiency and the evenness of the film thickness and describes a thin film formation method using a gas in which the pressure of the inside of a vacuum chamber is set so as to make the average free movement path of molecules contained in the supplied reactive gas longer than the shortest distance between a substrate the vacuum chamber and the exposed wall in the vacuum side of the vacuum chamber. This publication of the patent describes the correlation of the average free movement path d (m) of molecules to the temperature (K) of the gas, the pressure P (Pa) of the gas and the diameter D (m) of the gas molecule. As being defined as d = 3.11 × 10⁻²⁴ × T/(P × D²), the average free movement path is in inverse proportion to the second power of the diameter of the molecule of the gas. Since the diameter of the molecule of an organometal gas is 10 times as large as the diameter of Si₂H₆ molecule described in the publication of the patent, the average free movement path of the organometal gas is 1/100 of the average free movement path of Si₂H₆ or shorter. Subsequently, by the method described in the publication of Japanese Patent Laid-Open No. 5 - 251355, in terms of the apparatus, if a distance applicable for production is kept between a substrate and the vacuum side exposed wall of a vacuum chamber, the pressure of the vacuum chamber has to be set at 1 × 10⁻⁵ Torr.

In the case of forming a metal oxide dielectric film, it is required to introduce an oxidizing gas to sufficiently oxidize a metal supplied in a form of an organometal. In the atmosphere as thin as 1 × 10⁻⁵ Torr or thinner, it occurs a problem that oxidization cannot sufficiently be carried out, which causes deterioration of crystallinity. Further, in the atmosphere as thin as 1 × 10⁻⁵ Torr or thinner, it occurs a problem that the supply amount of a raw material to the substrate surface is a little and the film formation ratio is slow and that the cost is too high in the case of employing such a method for a semiconductor device fabrication method. Consequently, though the method is efficient for a molecule with a small diameter such as Si₂H₆, it is difficult to apply the method for film formation of a metal oxide dielectric film where a large molecule is used and sufficient oxidation is required. Furthermore, the substrate temperature described is very high, as high as about 700°C, so that the method is not suitable for the purpose of the present invention required to carry out film formation at a relatively low temperature. Moreover, no description is given regarding the orientation of the film, which is a very important and required property for a metal oxide dielectric film.

In conventional production of a ferroelectric memory or a DRAM, the foregoing film formation methods are employed, however heating at a high temperature around 600°C or higher in oxygen atmosphere is essential and crystal orientation has been difficult to be controlled.

To give a description of a semiconductor in terms of the structure, in order to make a ferroelectric capacitor and a high-dielectric-constant capacitor well functioning, it is required to electrically connect an electrode of either one of capacitors to a diffusion layer of a selective transistor. Conventionally, in a DRAM, it is general that polysilicon connected to one diffusion layer of a selective transistor is used as one electrode and that a SiO₂ film, a Si₃N₄ film, or the like is formed as a capacitive insulating film on the surface of the polysilicon to compose the capacitor structure. However, since the ceramic thin film is an oxide, polysilicon is oxidized when the thin film is to be formed directly on the surface of the polysilicon and owing to that, it is impossible to form a good thin film. Hence, 1995 Symposium on VLSI Technology Digest of Technical Papers p. 123 describes a cell structure in which the upper electrode of a capacitor and a diffusion layer are connected by a local wiring of a metal such as Al or the like. Also, International Electron Devices Meeting Technical Digest, 1994 p. 843, describes a technique of forming a PZT capacitor on polysilicon using a TiN barrier metal. Regarding a DRAM, for example, International Electron Devices Meeting Technical Digest, 1994 p. 831, describes a technique of forming a STO (strontium titanate SrTiO₃) thin film on a RuO₂/TiN lower electrode form on a polysilicon plug to compose a capacitor.

However, the following problems exist in the foregoing film formation methods. A first problem is that since the crystallization temperature of the metal oxide dielectric film is as high as 600°C or higher, even if TiN is used as a barrier metal as described International Electron Devices Meeting Technical Digest p. 843, oxidation of TiN is inevitable and the contact resistance is increased. Further, it is also difficult to use W and Al for a material of a plug instead of polysilicon. That is because W is easy to be oxidized and the temperature exceeds the melting point of A1. The practical upper limit temperatures of the respective metals are around 500°C for TiN and around 450°C for W, Al.

In Jpn. J. Appl. Phys. vol. 32 (1993) p. 4057, a sputtering method described is a method for controlling a composition and lowering the crystallization temperature of PZT to 415°C by simultaneously sputtering multiple targets of respective constituent metal oxides. However, the sputtering method has problems that the method is inferior in coating on stepped surfaces and that the method is difficult to be applied for film formation on side wall parts of a stack type or a trench type capacitor, and therefore, the method cannot be a countermeasure to a capacitor production technique for a semiconductor integrated circuit.

Also, Jpn. J. Appl. Phys. vol. 32 (1993) p. 4057 describes a method for lowering the crystallization temperature of PZT to 415°C by previously forming a buffer layer of PbLaTiO₃ (PLT) of 5 nm thickness on a Pt electrode and then sputtering PZT. However, the sputtering method has problems that the method is inferior in coating on stepped surfaces and that the method is difficult to be applied for film formation on side wall parts of a stack type or a trench type capacitor, and therefore, the method cannot be a countermeasure to a capacitor production technique for a semiconductor integrated circuit. Further, PLT is paraelectric and the dielectric constant is low as compared with that of PZT. Therefore, most part of the voltage is applied to the PLT layer at the time of operating the device. This makes it hard to obtain ferroelectric properties at low voltage.

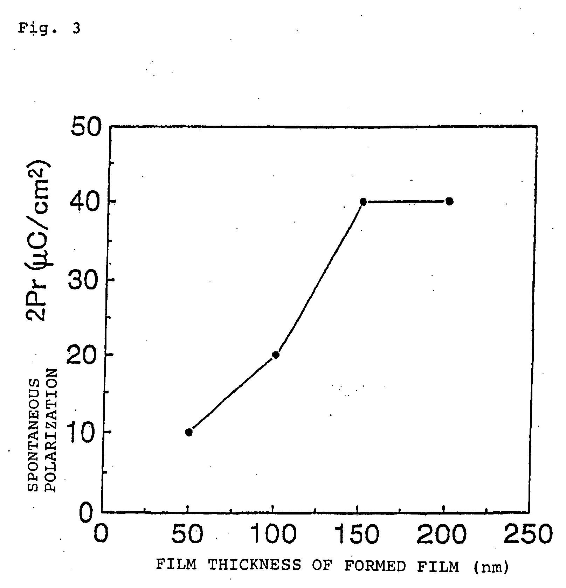

A second problem is that the properties of a dielectric film are deteriorated in the case of making the film thin. In order to achieve a high speed and make the structure ultrafine, it is essential to lower the voltage of a power source and in order to provide an electric field necessary for a capacitive insulating film, it is necessary to make the capacitive insulating film of the metal oxide dielectric film as thin as possible. Fig. 3 illustrates the film thickness and spontaneous polarization 2Pᵣ in the case of forming a PZT film on Pt by a sol-gel method. In the case of 200 nm or thinner of the film thickness, the spontaneous polarization value is found sharply decreased. A similar phenomenon is also observed in the case of BST. There exists a problem that the dielectric constant of a BST film formed on RuO₂ by a CVD method is sharply decreased in the case of 50 nm or thinner of the film thickness. That is attributed to inferior crystallinity in the vicinity of the interface of a lower part electrode. Owing to the foregoing problems, conventional film formation methods are found difficult to make a capacitive insulating film thin and to lower the voltage of a power source.

A third problem is that the orientation of the film cannot be controlled. To make the orientation even is advantageous in the following points. At first, the grain boundaries of the polycrystal become continuous to lower the current leakage. Secondary, the dielectric constant can be increased and the spontaneous polarization can be heightened by conforming the polarization direction to the electric field direction.

According to the description in Jpn. J. Appl. Phys. Vol. 32 (1993) P. 4075, it is described that PZT is epitaxially grown on a single crystal substrate of MgO(100) or Pt(100)/MgO(100) by a sputtering method and PZT significantly tends to be oriented to (001) orientation. However, it is also described that orientation is uneven in the case where a film is formed on polycrystalline Pt oriented to (111) just like for the case of Pt(111)/Ti/SiO₂ and considering that the capacitor electrodes of a semiconductor integrated circuit are polycrystalline, such a method cannot be a countermeasure.

A fourth problem is a problem of inversion fatigue in the ferroelectric film. That is a phenomenon that the quantity of electric charge between inversion and non-inversion is decreased if inversion of spontaneous polarization is repeated by applying voltage with sinusoidal or rectangular waveform to the ferroelectric film. Such a phenomenon is a serious problem which determinate the number of possible times of writing of a ferroelectric capacitor and determinately affects the life in the case where a non-volatile memory is fabricated using a ferroelectric material. However, as described in Jpn. J. Appl. Phys. Vol. 68 (1996) P. 1431, it is known that inversion fatigue occurs by inversion repeated only about 10⁶ times in the case where Pt is used for electrodes. A main memory like a dynamic random access memory (DRAM) is required to have a write life not less than 10¹¹ times and a non-volatile memory using the ferroelectric material thus has a problem that the memory does not satisfy such a long write life.

A fifth problem is that the particle size of the polycrystalline PZT cannot be controlled. As the high density integration of the device proceeds further, the surface area of a capacitive part is lessened. To follow this, it becomes important to optimize the particle size of a ceramic insulating film. In conventional examples, though the particle size is changed depending on the respective film formation methods, no effective method is reported to control the particle size in respective each film formation method.

A sixth problem is a matter of dust adsorption during film formation. In any conventional film formation method, e.g. a sol-gel method, a sputtering method, and a CVD method, with the film growing, raw materials or products adhere to an apparatus inner wall part or to a susceptor part or the like holding a wafer. Subsequently, adhered raw materials or products are parted and peeled off, then, these materials adhere to the wafer surface to cause a problem that device fabrication thereafter is obstacled.

For example, in a sol-gel method, a raw material solution is scattered to the apparatus inner walls at the time of spin coating and segments of a film of the dried scattered raw material adhere to the wafer surface. Also in a sputtering method, a material of a target adheres to the apparatus inner walls and being parted and scattered, the material pollutes the wafer surface.

In terms of a CVD method, in the case of a kind of methods employing a furnace for heating a wafer put therein by increasing the temperature of the walls, organometal gases are decomposed in the heated walls and the decomposed matter is scattered and pollutes the wafer surface.

As described above, there are a lot of problems to be solved in formation of a thin film capacitor of a metal oxide dielectric material on a plug and in formation of a metal oxide dielectric thin film capacitor on a multilayer metal wiring structure and thus the cell surface area cannot easily be narrowed just like a conventional DRAM and a flash memory and consequently, the integration degree has still been low.

### DISCLOSURE OF THE INVENTION

The present invention is developed while taking the above described problems in conventional methods for forming a capacitive insulation film of a metal oxide dielectric film into consideration and aims at providing a vapor phase growth method of a metal oxide dielectric film and capable of forming a metal oxide with excellent in both orientation and crystallinity on a plug at a low temperature and further aims at providing a semiconductor device made to have a fine structure, highly integrated, and multilayered and metallized by employing the vapor phase growth method.

Further, the present invention, relating to a vapor phase growth apparatus to be employed for the foregoing vapor phase growth of a metal oxide dielectric film, aims at providing a vapor phase growth apparatus capable of forming a metal oxide dielectric film with little dust adsorption by suppressing dust generation during the film formation.

The present invention relates to a vapor phase growth method of a metal oxide dielectric film on a substrate using organometal gases, in which the film formation is carried out by introducing the organometal gases and an oxidizing gas into a vacuum chamber through separate introduction inlets while heating the substrate set in the vacuum chamber in a condition to keep the substrate temperature at 450°C or lower during the film formation and keeping the total pressure of the vacuum chamber at 1 × 10⁻² Torr or lower.

Regarding the foregoing total pressure of the vacuum chamber, it is preferable to carry out film formation at 1 × 10⁻⁴ Torr or higher in order to obtain a practically high film formation rate.

Further, the present invention relates to a vapor phase-growth method of a metal oxide dielectric film on a substrate using organometal gases, that is, a vapor phase growth method of a metal oxide dielectric film, comprising a step of: introducing organometal gases and an oxidizing gas into a vacuum chamber through separate introduction inlets while heating the substrate set in the vacuum chamber in a condition to keep the substrate temperature at 450°C or lower during the film formation while controlling the gas supply conditions for the foregoing organometal gas and/or the foregoing oxidizing gas to be self-controlling conditions to obtain the foregoing metal oxide dielectric film having a prescribed composition and a crystal structure and keeping the total pressure in the vacuum chamber at 1 × 10⁻² Torr or lower. Moreover, in this vapor phase growth method, it is preferable to directly control the flow rates of the foregoing organometal gas and oxidizing gas without using a carrier gas and to introduce them to the foregoing vacuum chamber.

Further, in the foregoing vapor phase growth method, the foregoing oxidizing gas may comprise nitrogen dioxide and also the foregoing metal oxide dielectric film may be a PZT film or a BST film. In addition to that, a substrate having at least capacitor electrodes comprising a metal or a metal oxide of Pt, Ir, Ru, IrO₂, RuO₂, TiN, or WN thereon may be employed as the substrate.

Furthermore, in the foregoing vapor phase growth method, the temperature of the inner walls of the vacuum chamber may be equal to or higher than a temperature to allow the organometal gases to have a sufficiently high vapor pressure and equal to or lower than an organometal gas decomposition temperature.

The present invention further relates to a method for fabricating a semiconductor device, comprising: a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation film and burying a metal plug in the contact, a step of forming a capacitor lower part electrode layer on the whole surface of the first interlayer insulation film having the metal plug, a step of forming a metal oxide dielectric film on the whole surface of the capacitor lower part electrode layer using organometal gases and an oxidizing gas at 1 × 10⁻⁴ Torr or higher to 1 × 10⁻² Torr or lower of the total pressure while keeping the temperature of the semiconductor substrate at 450°C or lower, a step of forming a capacitor upper part electrode layer on the whole surface of the metal oxide dielectric film, and a step of patterning the lower part electrode layer, the metal oxide dielectric film, and the capacitor upper part electrode layer to obtain a capacitor with a three-layered laminated structure.

The present invention further relates to a method for fabricating a semiconductor device, comprising: a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation film and burying a metal plug in the contact, a step of forming a capacitor lower part electrode layer on the whole surface of the first interlayer insulation film having the metal plug, a step of forming a capacitor lower part electrode on the metal plug by patterning the capacitor lower part electrode, a step of forming a metal oxide dielectric film on the patterned capacitor lower part electrode and on the whole surface of the first interlayer insulation film using organometal gases and an oxidizing gas at 1 × 10⁻⁴ Torr or higher to 1 ×10⁻² Torr or lower of the total pressure while keeping the temperature of the semiconductor substrate at 450°C or lower, a step of forming a capacitor upper part electrode layer on the whole surface of the metal oxide dielectric film, and a step of patterning the capacitor upper part electrode layer to obtain a capacitor with a three-layered laminated structure of the capacitor lower part electrode, the metal oxide dielectric film, and the capacitor upper part electrode.

The present invention further relates to a method for fabricating a semiconductor device, comprising: a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation film and burying a metal plug in the contact, a step of forming an aluminum wiring electrically connected to the metal plug on the first interlayer insulation film, a step of forming a second interlayer insulation film on the aluminum wiring, a step of forming electric conduction by opening a contact reaching the aluminum wiring in the second interlayer insulation film and burying a metal plug, a step of forming a capacitor lower part electrode layer on the whole surface of the second interlayer insulation film including the metal plug, a step of forming a metal oxide dielectric film on the whole surface of the capacitor lower part electrode layer using organometal gases and an oxidizing gas at 1 × 10⁻⁴ Torr or higher to 1 × 10⁻² Torr or lower of the total pressure while keeping the temperature of the semiconductor substrate at 450°C or lower, a step of forming a capacitor upper part electrode layer on the whole surface of the metal oxide dielectric film, and a step of patterning the capacitor lower part electrode layer, the metal oxide dielectric film, and the capacitor upper part electrode layer to obtain a capacitor with a three-layered laminated structure.

The foregoing aluminum wiring may be formed in multilayers.

Further, the present invention relates to a vapor phase growth method for carrying out film formation of a metal oxide dielectric film with a perovskite type crystal structure represented by ABO₃ on a conductive material using organometal gases, comprising steps of: carrying out initial nuclei formation of the perovskite type crystal structure on the conductive material using all of the organometal gases to be the raw materials of the metal oxide dielectric film under first film formation conditions, and carrying out film formation of the perovskite type crystal structure further on the initial nuclei under second film formation conditions.

Further, the present invention relates to a vapor phase growth method for carrying out film formation of a metal oxide dielectric film with a perovskite type crystal structure represented by ABO₃ on a conductive material using organometal gases, comprising steps of: carrying out initial layer formation of the perovskite type crystal structure on the conductive material using all of the organometal gases to be the raw materials of the metal oxide dielectric film under first film formation conditions and carrying out film formation of the perovskite type crystal structure further on the initial layer under second film formation conditions.

Further, the present invention relates to a vapor phase growth method for carrying out film formation of a metal oxide dielectric film with a perovskite type crystal structure represented by ABO₃ on a conductive material using organometal gases, comprising steps of: carrying out initial nuclei formation of the perovskite type crystal structure on the conductive material using only a part of the organometal gases to be the raw materials of the metal oxide dielectric film under first film formation conditions and carrying out film formation of the perovskite type crystal structure further on the initial nuclei under second film formation conditions.

Regarding the supply amounts of raw material gases in the first film formation conditions and the second film formation conditions, it is preferable to control the second film formation conditions as to carry out film formation using raw material gas supply in good self-controlling conditions and also preferable to control the first film formation conditions so that the raw material of the A element of the perovskite type crystal structure represented by ABO₃ is supplied in a higher quantity than that in the second film formation conditions

In addition to that, it is preferable to control the first film formation conditions as to relatively decrease the supply amount of Zr in the B element, in the case where the perovskite type crystal structure represented by ABO₃ contains Zr and Ti as the B element, as compared with that in the second film formation conditions.

Further, in an embodiment of the present invention, the first film formation conditions are so controlled as to supply no Zr raw material gas to carry out film formation in the case the perovskite type crystal structure represented by ABO₃ contains Zr and other elements as the B element.

Further, in an embodiment of the present invention, the film formation is carried out while controlling the crystal grain size by controlling the initial nucleus formation duration in the first film formation conditions.

Further, in the present invention, it is preferably to form a film in conditions where the total pressure of the raw material gases including the organometal gases at the time of film formation is kept at 1 × 10⁻² Torr or lower and the film formation temperature is kept at 450°C or lower. The lower limit of the total pressure is not specifically restricted but it is preferably at 1 × 10⁻⁴ Torr or higher in order to obtain a practical film formation rate.

Incidentally, in the present invention, the film formation temperature is preferably 450°C or lower.

Further, an embodiment of the present invention is characterized in that the metal oxide dielectric film is a PZT film or BST film.

Further, in an embodiment of the present invention, the conductive material is a capacitor electrode comprising at least any one of metals and metal oxides of Pt, Ir, Ru, IrO₂, RuO₂, TiN, and WN.

Further, the present invention relates to a method for fabricating a semiconductor device, comprising: a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation film and burying a metal plug in the contact, a step of forming a capacitor lower part electrode layer on the whole surface of the first interlayer insulation film having the metal plug, a step of forming initial nuclei or an initial layer of a metal oxide dielectric film having the perovskite type crystal structure on the whole surface of the capacitor lower part electrode layer using organometal gases under the first film formation conditions and further forming the metal oxide dielectric film having the perovskite type crystal structure on the initial nuclei or the initial layer under the second film formation conditions, a step of forming a capacitor upper part electrode layer on the whole surface of the metal oxide dielectric film, and a step of patterning the capacitor lower part electrode layer, the metal oxide dielectric film, and the capacitor upper part electrode layer to obtain a capacitor with a three-layered laminated structure.

Further, the present invention relates to a method for fabricating a semiconductor device comprising: a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation film and burying a metal plug in the contact, a step of forming a capacitor lower part electrode layer on the whole surface of the first interlayer insulation film having the metal plug, a step of forming a capacitor lower part electrode on the metal plug by patterning the capacitor lower part electrode layer, a step of forming initial nuclei or an initial layer of a metal oxide dielectric film having the perovskite type crystal structure on the whole surface of the patterned capacitor lower part electrode and the first interlayer insulation film layer using organometal gases under the first film formation conditions and further forming the metal oxide dielectric film having the perovskite type crystal structure on the initial nuclei or the initial layer under the second film formation conditions, a step of forming a capacitor upper part electrode layer on the whole surface of the metal oxide dielectric film, and a step of patterning the capacitor upper part electrode layer to obtain a capacitor with a three-layered laminated structure of the capacitor lower part electrode, the metal oxide dielectric film, and the capacitor upper part electrode.

Further, the present invention relates to a method for fabricating a semiconductor device, comprising a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation film and burying a metal plug in the contact, a step of forming an aluminum wiring on the first interlayer insulation film to electrically connecting the aluminum wire with the metal plug, a step of forming a second interlayer insulation film on the aluminum wiring, a step of forming electric conduction by opening a contact reaching the aluminum wiring in the second interlayer insulation film and burying a metal plug in the contact, a step of forming a capacitor lower part electrode layer on the whole surface of the second interlayer insulation film having the metal plug, a step of forming initial nuclei or an initial layer of a metal oxide dielectric film having the perovskite type crystal structure on the whole surface of the whole surface of the capacitor lower part electrode layer using organometal gases under the first film formation conditions and further forming the metal oxide dielectric film having the perovskite type crystal structure on the initial nuclei or the initial layer under the second film formation conditions, a step of forming a capacitor upper part electrode layer on the whole surface of the metal oxide dielectric film, and a step of patterning the capacitor lower part electrode layer, the metal oxide dielectric film, and the capacitor upper part electrode layer to obtain a capacitor with a three-layered laminated structure.

The foregoing aluminum wiring may be multilayered.

Further, the present invention relates to an apparatus to be employed for vapor phase growth of a metal oxide dielectric material on a substrate in a vacuum chamber using organometal gases and an oxidizing gas as raw material gases by brining these gases into contact with one another, comprising: an apparatus part to be brought into contact with raw material gases and to be heated to the temperature equal to or higher than the decomposition temperature of the raw material gases; at least the surface of the apparatus part to which the raw material gases contact being made of a metal oxide dielectric material (hereafter referred to as a high temperature part-coating dielectric material) same or not same as the metal oxide dielectric material to be grown.

Though the decomposed products of raw material gases are deposited when the raw material gases are brought into contact with the part(s) which are heated at the temperature equal to or higher than the decomposition temperature of the raw material gases, parting of the deposited decomposed products does not take place in the case where the parts to be brought into contact with the raw material gases are made of the high temperature part-coating metal oxide dielectric material and subsequently. Therefore, the generation of particles can be suppressed. It is also sufficient that, in the part(s), a portion of surface thereof to be brought into contact with the raw material gases is coated with the high temperature part-coating dielectric material. Or, the whole body of the parts may be made of the high temperature part-coating dielectric material.

The high temperature part-coating dielectric material may be the same or not the same as the metal oxide dielectric material to be grown. An apparatus of the present invention for vapor phase growth is suitable for growing a metal oxide dielectric film on a substrate and since a ferroelectric material and a high-dielectric-constant material are preferable as the metal oxide dielectric material to be grown, a ferroelectric material and a high-dielectric-constant material are also used as the high temperature part-coating dielectric material.

The apparatus parts to be brought into contact with the raw material gases and to be heated to the temperature equal to or higher than the decomposition temperature of the raw materials gases include any parts which satisfy such condition and disposed in the apparatus for the vapor phase growth. Among these, a susceptor for supporting a wafer is an example part representative of such apparatus parts. And at the same time, effect is the most prominent if the high temperature part-coating dielectric material is applied to the susceptor.

Further, in the present invention, the foregoing apparatus for vapor phase growth comprises wall heating means for heating the walls of a vacuum chamber and it is preferable to set the temperature of the walls not lower than the temperature at which the organometal gases have sufficiently high vapor pressure and not higher than the decomposition temperature of the organometal gases.

Further, the present invention relates to a vapor phase growth apparatus to be employed for vapor phase growth of a metal oxide dielectric material on a substrate in a vacuum chamber using organometal gases and an oxidizing gas as raw material gases by bringing the gases into contact with one another on the substrate, comprising: an apparatus part to be brought into contact with the raw material gases and to be heated to the temperature equal to or lower than the decomposition temperature of the raw material gases; at least the surface of the apparatus part to which the raw material gases contact being made of aluminum oxide. Since the organometals of the raw materials hardly adhere to the faces made of aluminum oxide, particle generation can be suppressed.

Such parts to be coated with or made of aluminum oxide include any parts which satisfy such conditions as to be brought into contact with the foregoing raw material gases and to be heated to not higher than the decomposition temperature of the raw material gases. Among these, the inner wall is an example part representative of such parts. And at the same time, effect is the most prominent if aluminum oxide is applied to the wall.

Further, the present invention relates to a vapor phase growth apparatus to be employed for vapor phase growth of a metal oxide dielectric material on a substrate in a vacuum chamber using organometal gases and an oxidizing gas as raw material gases by bringing these gases into contact with one another on the substrate, comprising: a valve capable of opening at the time when a substrate is put in and taken out between the forgoing vacuum chamber and an exchange chamber and with a movable shielding plate in the vacuum chamber side of the valve for preventing adhesion of raw material gases to the valve.

### BRIEF DESCRIPTION OF THE DRAWINGS

Fig. 1 is a diagrammatic illustration showing the cross-section of a vacuum chamber of an apparatus for vapor phase growth of a thin film to be employed for the present invention;
Fig. 2 is a diagrammatic illustration showing a conventional example of a reactive gas supply method in the case of using a carrier gas;
Fig. 3 shows a graph illustrating the correlation between the film thickness and the spontaneous polarization 2Pᵣ in the case of PZT film growth on Pt using a sol-gel method;
Fig. 4 is a schematic diagram of a thin film formation pattern in the case of metal oxide dielectric film growth with the perovskite type crystal structure on an electrode;
Fig. 5 shows a graph illustrating the alteration of the (Ti + Zr)/Pb composition ratio in a film in the case of altering the Pb raw material flow rate;
Fig. 6 is a diagrammatic illustration of an apparatus for vapor phase growth of a thin film to be employed for the present invention;
Fig. 7 is a diagrammatic illustration showing the raw material supply system of an apparatus for vapor phase growth of a thin film to be employed for the present invention;
Fig. 8 shows x-ray diffraction spectra in the case of keeping film formation conditions (the first film formation conditions and the second film formation conditions) constant and changing the film formation temperature;
Fig. 9 shows a graph illustrating the alteration of the ratio of crystal grains of PZT polycrystal having (100) crystal axis in the perpendicular direction to the substrate, being computed from x-ray diffraction spectra, in the case of changing the film formation temperature;
Fig. 10 shows a graph illustrating the alteration of the height of the PZT (100) peak appearing in the x-ray diffraction spectra in the case of changing the total pressure without changing the ratio of partial pressure of each organometal gas;
Fig. 11 shows a graph illustrating the alteration of the height of the PZT (100) peak appearing in the x-ray diffraction spectra in the case of keeping the substrate temperature at 400°C and introducing argon into the vacuum chamber and changing the introduction quantity of argon without changing the flow rate of each organometal gas and the exhaust rate;
Fig. 12 shows a graph illustrating the dependency of the spontaneous polarization on the film thick in the case of PZT film formation by the vapor phase growth method of the present invention;
Fig. 13 shows a graph illustrating the comparison of x-ray diffraction spectra of the cases of using O₂ and NO₂ as oxidizing agents in PZT film formation at 400°C substrate temperature and in the same conditions;
Fig. 14 shows a graph illustrating alteration of the composition ratios of Zr/Pb, Ti/Pb in the case of altering the flow rate of NO₂ while keeping the flow rates of organometal gases of Pb, Zr, and Ti constant;
Fig. 15 shows the correlation between the pressure and the film formation rate at the time of film formation;
Fig. 16 shows a graph illustrating the in-plane distribution of the film thickness in a 6-inch wafer in the case of changing the total pressure without changing the ratio of the partial pressure of each organometal gas;
Fig. 17 shows a graph illustrating the in-plane distribution of the film thickness in the case of changing the temperature of the inner walls of the vacuum chamber;
Fig. 18 shows a graph illustrating the alteration of the Ti/Zr composition ratio in the film in the case of changing the flow rate of the Ti raw material;
Fig. 19 shows graphs illustrating the alteration of the x-ray diffraction spectra of PZT in the case of changing the flow rate of the Ti raw material;
Fig. 20 shows graphs illustrating the alteration of the hysteresis characteristics of PZT in the case of changing the flow rate of the Ti raw material;
Fig. 21 shows a graph illustrating the alteration of the ratio of the film thickness of the upper face and the film thickness of the side face in the case of PZT film formation on an electrode having a step of 500 nm height and 500 nm width while changing the total pressure;
Fig. 22 shows a graph illustrating the total number of particles on each 6-inch wafer in the case of continuously conducting film formation on 1,000 wafers while changing the total pressure without changing the partial pressure of each organometal gas;
Fig. 23 shows a graph illustrating the total number of particles on each 6-inch wafer in the case of continuously conducting film formation on 1,000 wafers while changing the temperature of the inner walls of the vacuum chamber;
Fig. 24 is an x-ray diffraction spectrum in the case of PZT film formation in prescribed film formation conditions alone;
Fig. 25 is an x-ray spectrum in the case of PZT film formation by optimized first film formation conditions and optimized second film formation conditions;
Fig. 26 shows a graph illustrating the composition ratios of Ti/Pb and Zr/Pb in the case of changing only the film formation temperature while keeping the first film formation conditions and the second film formation conditions constant;
Fig. 27 shows a graph illustrating the dependency of spontaneous polarization on the number of inversion times in the case of PZT film formation by a vapor phase growth method of the present invention;
Fig. 28 shows a graph illustrating the correlation of the initial nucleus formation time and the particle size of PZT in the first film formation conditions;
Fig. 29 is a schematic diagram showing the fabrication process of memory cells, which is one embodiment of the present invention. This illustration especially shows the fabrication process in which three layers of a capacitor upper part electrode layer, a capacitor lower part electrode layer, and a metal oxide dielectric film are simultaneously separated;
Fig. 30 is a schematic diagram showing the fabrication process of memory cells, which is one embodiment of the present invention. These illustrations especially show the fabrication process in which a capacitor upper part electrode layer and a capacitor lower part electrode layer are separated in respective steps and a metal oxide dielectric film is left in layered state (not.separated) in the memory cells;
Fig. 31 is a schematic diagram showing the fabrication process of memory cells, which is one embodiment of the present invention. These illustrations show the first half fabrication process of the memory cells in the case of especially a semiconductor device comprising memory cells having the aluminum-multilayered wiring structure;
Fig. 32 is a schematic diagram showing the fabrication process of memory cells, which is one embodiment of the present invention. These illustrations show the latter half fabrication process of the memory cells in the case of especially a semiconductor device comprising the memory cells having the aluminum-multilayered wiring structure;
Fig. 33 is a diagrammatic illustration showing the cross-section of one example of a vacuum chamber of a vapor phase growth apparatus of the present invention;
Fig. 34 is a diagrammatic illustration of a double gate valve to be employed for the present invention;
Fig. 35 shows a graph illustrating the correlation of the number of wafers on which films are continuously formed and the total number of particles in the case of PZT formation on 6-inch wafers using a quartz susceptor and a quartz susceptor on which a 100 µm STO is formed by sintering; and
Fig. 36 shows a graph illustrating the correlation of the number of wafers on which films are continuously formed and the total number of particles in the case of PZT formation on 6-inch wafers in the case of using aluminum oxide for the material of the inner walls of the vacuum chamber and in the case of using a stainless steel for the material of the inner walls.

### BEST MODE FOR CARRYING OUT THE INVENTION

Inventors of the present invention have found that the film. formation at a low temperature is possible by controlling the total pressure to be 1 × 10⁻² Torr or lower at the time of film formation in the case of forming a metal oxide dielectric film on a capacitor electrode using organometal gases and further that the film formation of a highly excellently oriented film is possible.

That is, within the foregoing pressure range, even at a temperature of 450°C or lower, approximately 100% of PZT has been found oriented in the PZT(100) direction. The temperature is, as compared with the film formation temperature of a conventional method, a low film formation temperature by about 150°C or more. Consequently, for example, film formation can be carried out without oxidation of W, TiN or the like formed in the contact plug and fusion of an Al wiring formed on a substrate. As a result, by a vapor phase growth method of the present invention, a metal oxide dielectric film with uniform orientation can be formed on a semiconductor substrate on which a TiN or W layer and an Al wiring if formed.

The reason why a crystal with uniform orientation is formed without increasing the temperature, inventors of the present invention presume as follows. Inventors of the present invention suppose whether formation of a crystal with uniform orientation is possible or not depends on the frequency of the collision of molecules of organic metal gases and an oxidizing gas. That is, if the total pressure of a vacuum chamber is 1 × 10⁻² Torr or higher, molecules of organic metal gases and an oxidizing gas repeat collision a large number of times before they reach the substrate and fine crystals with uncontrolled compositions are formed and the fine crystals become causes of disorder of the crystal structure and therefore, it can be supposed that if the pressure is in a range of 1 × 10⁻² Torr or lower, such fine crystal formation can practically be suppressed and the crystal structure tends to easily be uniform even at a low temperature.

However, in order to obtain a practically applicable film formation rate, the film formation is preferable to be carried out at higher than 1 × 10⁻⁴ Torr and most preferable to be carried out at a pressure within a range from 1 × 10⁻³ Torr to 1 × 10⁻² Torr.

Incidentally, the organometal gases mean raw material gases of organometals necessary to form a desired ferroelectric film or a high-dielectric-constant film on a capacitor electrode. For example, in the case of a PTZ film, examples of the organometal gases include gases of lead bis(dipivaloylmethanate) (Pb(DPM)₂), tetra(tert-butoxy) zirconium (Zr(OtBu)₄), tetra(isopropoxy) titanium (Ti(OiPr)₄), and the likes. In the case of a BST film, examples include gases of barium bis(dipivaloylmethanate) (Ba(DPM)₂), strontium bis(dipivaloylmethanate) (Sr(DPM)₂), tetra(isopropoxy) titanium (Ti(OiPr)₄), and the likes.

Further, the inventors of the present invention have found that the total pressure of the gases of a vacuum chamber decreases more, the film thickness in the plane becomes more even. Especially, it has been found that by suppressing the total pressure to 1 × 10⁻² Torr or lower, the in-plane evenness (the difference between the thickest film thickness and the thinnest film thickness) is controlled to a degree as high as about 5% in the case of 6-inch wafers.

Further, the inventors of the present invention have studied of correlation of the stepped-surface coating capability to the total pressure of the gases in a vacuum chamber. Investigation was carried out by experimentally forming a film on a substrate with grooves of 500 nm height and 500 nm width. The ratio of-film thickness on the upper face and of the film thickness on the side faces of the grooves was measured to evaluate the film thickness evenness (the stepped-surface coating capability). As a results, when the total pressure is 1 × 10⁻² Torr or lower, the film thickness ratio exceeds 0.75 and a significantly high stepped-surface coating capability is obtained .

An oxidizing gas is an essential component to allow organometal gases to be deposited on a capacitor film in state that these gases are sufficiently oxidized. The kinds of the oxidizing gases can properly be selected responding to the raw material gases as to prevent inconvenience such as alloying of each organometal gas owing to reduction of the gas on the surface of a capacitor electrode. For examples, the oxidizing gases include gases of O₂, NO₂, ozone, oxygen radical, oxygen ion, and the likes. Among these, those with high oxidizing force are preferable and, in terms of example, NO₂ is preferable.

Incidentally, oxygen radical and oxygen ion can be obtained by, for example, installing a plasma source such as ECR in a film formation chamber and dissociating oxygen in plasma. Consequently, an apparatus for carrying out a vapor phase growth method of the present invention may be equipped with such an oxygen radical and/or oxygen ion generation apparatus.

Since an oxidizing gas has oxidizing force to organometal gases as just described, in order to quantitatively introduce respective gases into a vacuum chamber, respective gases are required to be separately introduced so as to keep respective gases from one another.

By controlling the gas supply conditions of respective organometal gases or oxidizing gas or both of these gases, film formation is made possible in self-controlling gas supply conditions as to provide a metal oxide dielectric film with a prescribed composition and a crystal structure.

Regarding the flow rate of the respective raw materials of organometal gases and an oxidizing gas, there exists a self-controlling flow rate ratio as to allow the crystal structure to spontaneously have the perovskite type crystal structure and flow control may be carried out within the range. Regarding also the flow rate of an oxidizing gas, if the flow rate is low, the oxidizing force is insufficient to organometal gases and metals themselves are possibly deposited and hence, as same in the case of organometal gases, it is preferable to carry out film formation while controlling the flow rate in a flow rate range in which the film can be provided with an evenly oriented perovskite type crystal structure.

It is preferable for a method for introducing organometal gases into a vacuum chamber to directly control the flow rate to introduce the organometal gases without using a carrier gas. That is, introduction of a gas irrelevant to the crystal growth results in increase of the total pressure during the film formation and difficulty of formation of an evenly oriented perovskite type crystal structure and thus a formed metal oxide dielectric film cannot sufficiently show high ferroelectric properties and high dielectric properties. A method for controlling the flow rate employing a mass flow controller is one of examples of a method for directly controlling flow rate without using a carrier gas.

Regarding a vacuum chamber, it is preferable for the inner walls of the vacuum chamber to be controlled at not lower than a temperature at which the organometal gases can have sufficiently high vapor pressure and not higher than a decomposition temperature of the organometal gases. The reason for that is because the organometal gases and their decomposed products have to be refrained from adhering to the inner walls of the vacuum chamber and the temperature control is effective to improve the in-plane evenness of the film thickness and to suppress particle formation.

Further, in the case where a metal oxide dielectric film to be formed on an electrode has the perovskite type crystal structure represented by ABO₃, the film formation conditions are changed to be first film formation conditions in which initial nuclei or an initial layer with the perovskite type crystal structure is formed on an electrode and successive second film formation conditions in which a film with the perovskite type crystal structure is formed on the formed initial nuclei or layer. In contrast, according to a conventional film formation method, film formation on a conductive material has been carried out in same conditions through the process. In the present invention, it is also possible to select optimized conditions for the respective film formation conditions to carry out film formation. By carrying out film formation in such conditions, formation of a film with excellent in orientation property, crystallinity, and property relating inversion fatigue is made possible.

In general, the perovskite type crystal structure is represented by ABO₃ where the element A occupies site A and the element B occupies site B site. Incidentally, in some cases, a plurality of metal elements are contained as the A element and the B element of the foregoing general formula. At the time of carrying out vapor phase growth of a metal oxide dielectric film having such a perovskite type crystal structure on a conductive material, in the case of film formation using all of the raw material gas seeds of elements constituting a metal oxide dielectric film in first film formation conditions, a perovskite type crystal of either initial nuclei or an initial layer of crystallized some molecules in the film thickness direction is formed under the first film formation conditions. After that, a crystal is further grown on the foregoing initial nuclei or the foregoing initial layer under the second film formation conditions, which is raw material gas supply conditions enabling self-controlling film formation, so that a film with the perovskite type crystal structure and even orientation can be grown from the interface to the conductive material.

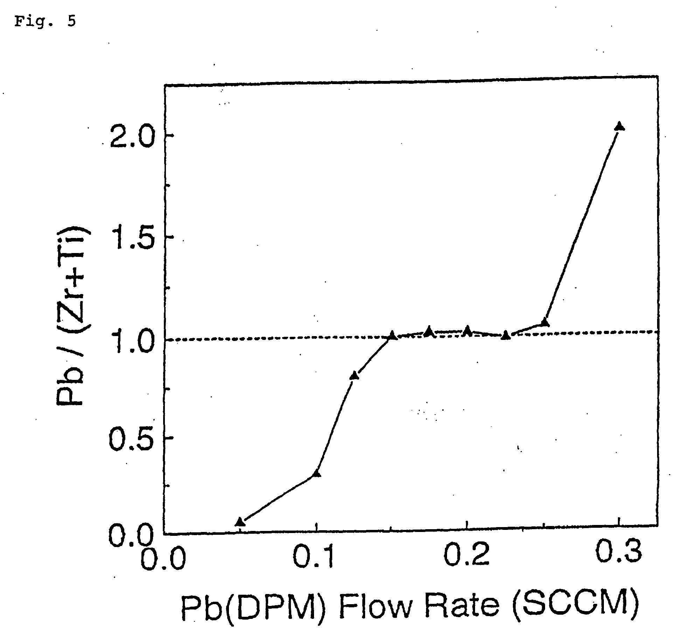

The self-controlling film formation conditions mean raw material gas supply conditions to generate a perovskite type crystal structure whose composition spontaneously satisfies the stoichiometric ratios and whose orientation is made even. For example, the self-controlling film formation conditions in the case of PZT film formation will be described with reference to Fig. 5. This Fig. 5 illustrates the alteration of the composition ratio of (Ti + Zr)/Pb in films. Film formation of these films are first conducted for 40 seconds under the conditions of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂; and then the flow rate of the raw material for Pb was changed while constantly keeping the conditions of 0.225 SCCM flow rate of Zr(OtBu)₄, 0.2 SCCM flow rate of Ti(OiPr)₄, and 3.0 SCCM flow rate of NO₂. And the change of (Ti + Zr)/Pb in the resulting films was measured. The total pressure of the gases in a vacuum chamber during the film growth was controlled to be 5 × 10⁻³ Torr. A substrate produced by forming a 200 nm thick Pt film on a silicon wafer bearing a 500 nm thick silicon oxide film thereon by sputtering was employed as a substrate. The duration of the film formation was set for 600 seconds and the thickness of the grown film was about 100 nm. The composition ratio were computed based on composition analysis by fluorescence x-rays. It was understood that the composition ratio reached the stoichiometric ratio when the flow rate of Pb was 0.15 SCCM; and that the stoichiometric ratio thereafter was kept by increasing the Pb flow rate even to 0.25 SCCM to prove formation of a crystal with a perovskite type crystal structure with even orientation. In such a manner, it can be understood that self-controlling film formation is possible to conform the composition of A, B sites, that is, Pb with Zr and Ti to the stoichiometric ratio in prescribed film formation conditions. That is based on the following principle. The Pb organometal gas is decomposed on the PZT surface and oxidized to PbO. The adhesion coefficient of PbO on the PZT is low and hence no film formation occurs only by passing the Pb organometal gas to the PZT surface. If Ti and Zr are supplied, PbO on the surface is bonded to Ti or Zr on the surface before being released to the vapor phase and immobilized on the surface. Consequently, even if a Pb raw material is supplied excessively to a certain extent, Pb which is not bonded to Ti or Zr is released in gaseous phase to result in existence of a self-control region to give a stoichiometric ratio.

The most important point in film formation of a perovskite-type metal oxide dielectric film of such as PZT, BST, and the like on an electrode of Pt or Ir is generation of perovskite-type crystal nuclei on the substrate with a different crystal structure such as Pt or Ir. A perovskite-type metal oxide dielectric film on an electrode can be grown in the following manner. Raw material gases are decomposed at first on an electrode; precursors of constituent elements are adsorbed thereon; crystal nuclei are formed by integration of the precursors; the crystal nuclei are further grown to form an integrated layer-like form. Especially, at the time of crystal nucleus growth, the concentrations of the precursors of the constituent elements on the electrode surface are determined by the decomposition efficiency and the adhesion coefficient of each raw material on the base electrode and further by the diffusion of the raw materials into the electrode. It is, therefore, impossible to cause perovskite-type crystal nuclei formation if the concentrations on the surface are not conformed to the stoichiometric ratio of the substance to be grown to a film. The decomposition efficiency and the adhesion coefficient of each raw material gas on the surface of base electrode are different from those on the surface of PZT crystalline; therefore even if the film formation conditions are so determined as to conform the stoichiometric ratio of the composition of the film after thick film was formed, the composition formed on the base electrode at the moment of crystal nuclei formation, which is most important in the crystal growth, cannot be conformed to stoichiometric ratio. Therefore the crystallization does not take place

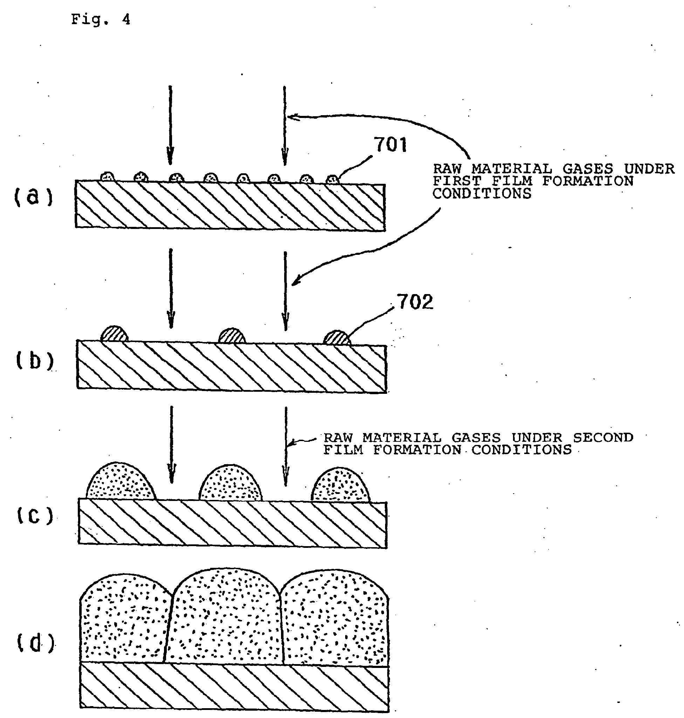

Further, inventors of the present invention have found that the element A to be disposed in the A site is easy to be alloyed with a conductive material composing an electrode and easy to be diffused in the electrode. Consequently, in order to prevent deficiency of the A element in the vicinity of the interface by diffusion, it is necessary to supply a rather large amount of the A element in the first film formation conditions. The amount of the A element in the first film formation conditions can be increased so that the supply ratio of A element to that of B element may be increased by about 10 times of the ratio prescribed in the second film formation conditions which are self-controlling gas supply conditions of the film formation. In the case of multiple element system in which the A element or the B element is composed of a plurality of elements, the increased amount is determined by the total of the supply amounts of these elements. For example, in the case of PZT film formation as shown in Figs. 4, inventors of the present invention optimized the first film formation conditions for generation of nuclei of PZT on the electrode by increasing the supply amount of the Pb raw material more than that of the second film formation conditions of self-controlling film formation of PZT on the PZT crystal nuclei. Thus, the generation of crystal nuclei 702 on an electrode is carried out by conforming the concentrations of the precursors 701 of constituent elements on the electrode surface to the stoichiometric ratio. Thereafter, excellent crystal growth on the crystal nuclei 702 is carried out.

That is, Pb, which is the A element of the constituent elements, most easily causes reaction with the base electrode and is easily removed from the electrode. The reaction of Pb with the base electrode is determined by the film formation temperature and the electrode materials and since the film formation temperature is increased more, the reaction with the electrode is intensified more, the supply amount of Pb is required to be increased more in the film formation conditions during generating PZT nuclei. Further, since Pt, as compared with Ir and Ru, has high reactivity to Pb, a further more Pb raw material is required to be supplied in the case of using Pt as the conductive material. In the case of forming BST, in the same manner, a Ba raw material has to be supplied more, though it is not so much as in the case of Pb.

Inventors of the present invention have found that more excellent PZT crystal nuclei were formed by lessening a Zr raw material in comparison with a Ti raw material in the case of using both of Zr and Ti as the B element. That is because the decomposition efficiency of the Zr raw material on an electrode is high as compared with that of the Ti raw material.

Though described above is the description of the case of formation of a perovskite-type metal oxide dielectric material represented by ABO₃, the same method can be applied for materials with other structures. That is, to supply an element most easily alloyed with an electrode material or diffused in the electrode material in a large amount in the initial period of the growth is effective to film formation of any kind of compounded metal oxides.

Further, inventors of the present invention have found that, in the case of carrying out generation of initial nuclei of perovskite type crystal structure represented by ABO₃, the initial nuclei formation is carried out using a part of raw material gases of especially the A element or the B element and then film formation is carried out further on the initial nuclei under the second film formation conditions. That is because, at the time of initial nucleus formation, a substance with a simpler composition is easy to control the film formation conditions to cause perovskite type nuclei generation.

Inventors of the present invention have found that, when a PZT film is formed, the first film formation conditions can be easily controlled when the nuclei generated have a simple binary composition of PTO; and that when BST is formed, the first film formation conditions can be easily controlled when the nuclei generated have a simple binary composition of BTO. That is because the control of the composition ratio can be performed by controlling especially only two elements. However as shown in Figs. 4, the important point in nuclei formation is that the film formation of PZT or BST has to be carried out by changing the film formation conditions to the second film formation conditions in self-controlling regions before the formed nuclei becomes a continuous film. The reason for that is if a continuous film is formed, an insulation film with a different composition and a different dielectric constant is formed in the interlayer to an electrode, which causes unevenness of an electric field in the film and decreases the dielectric constant of the film. Once perovskite type crystal nuclei 702 are formed on the electrode, the precursors 701 of the constituent elements are grown to form a film around the crystal nuclei in the self-controlling manner, so that an excellent crystal can be obtained by changing the conditions to the second film formation conditions in which PZT film formation on the crystal nuclei takes place in the self-controlling manner. Further, inventors of the present invention have found that the crystal grain size of a metal oxide dielectric film grown on initial nuclei can be controlled by controlling the duration period of the initial nuclei formation in the first film formation conditions and, in order to control the crystal grain size in such a manner, the first film formation conditions have to be restricted only to the stage of the initial nuclei formation.

The organometal gases to be employed are raw material gases of organometals necessary to form a perovskite type crystal structure represented by ABO₃ having ferroelectric or high dielectric properties and gases for forming the forgoing PZT film and BST film can be exemplified. Additionally, it is preferable to use an oxidizing gas, besides the organometal gases, to sufficiently oxidize the organometal gases to avoid alloying of the gases on a conductive material and to prevent oxygen deficiency and nitrogen dioxide, ozone, oxygen, oxygen ion, and oxygen radical can be used as the oxidizing gas. Among these, nitrogen dioxide is preferable because this has the highest oxidizing force.

As described before, also in this vapor phase growth method, low temperature film formation and moreover, film formation with highly oriented state are made possible by suppressing the total pressure to 1 × 10⁻² Torr or lower at the time of film formation.

That is, within the foregoing pressure range, even at a temperature of 450°C or lower, approximately 100% of PZT has been found oriented in the PZT(100) direction. As compared with the film formation temperature of a conventional method, the film formation temperature has been lowed by about 150°C or more.

Conductive materials to be employed for the present invention include metals such as Pt, Ir, Ru, TiN, WN, and the likes and metal oxides such as IrO₂, RuO₂, and the likes. These are employed for capacitor electrode. In the case of Pt as a conductive material, if the Pt is layered on TiN layered on Ti with a Pt/TiN/Ti structure, TiN functions as a barrier to suppress diffusion of Ti. Further, since TiN of the structure has a crystal structure highly oriented to (111), Pt is also oriented to (111). However, being different from a conventional film formation method, a vapor phase growth method of the present invention has been found having an advantageous point that a metal oxide dielectric film is easy to be oriented and to be provided with excellent crystallinity. In a contact plug, W is also commonly used and a Pt/TiN/Ti/W structure, which is produced by further forming a W layer in the lower layer of the foregoing structure can also be used preferably for a conductive material for the present invention.

Hereafter, an embodiment of the present invention will be described with reference to Figs.

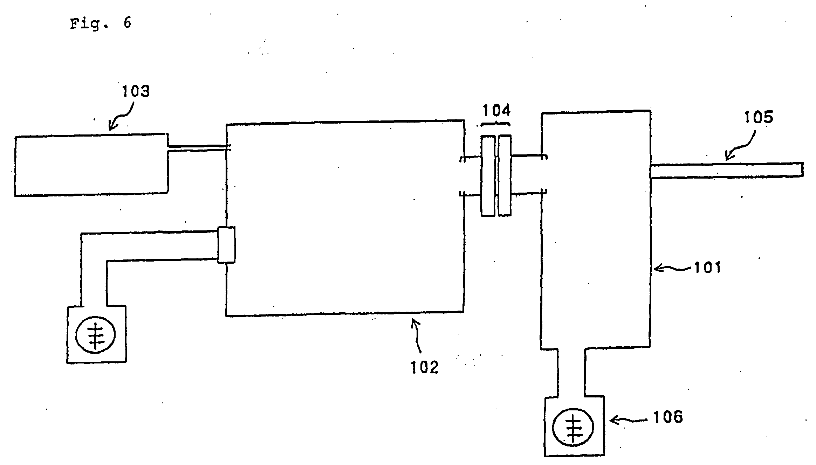

A schematic diagram of one example of a thin film vapor phase growth apparatus to be employed for the present invention is illustrated in Fig. 6. The present apparatus is composed of an exchange chamber 101, a vacuum chamber 102, and a raw material supply system 103 and a plurality of sheets of 8-inch wafers can be housed in the exchange chamber. Double gate valves 104 are installed between the vacuum chamber and the exchange chamber and the space between the two gate valves is evacuated by a pump. A wafer transferring mechanism 105 is installed for transferring wafers between the-vacuum chamber and the exchange chamber. With such a constitution, wafers can be replaced and transferred without the vacuum chamber being exposed to atmospheric air. Further, the double insertion of the gate valves is effective to suppress adhesion of the raw materials to the valve seal face and prevent leakage of atmospheric air in the vacuum chamber at the time of atmospheric air leak in the exchange chamber for replacing wafers. The exchange chamber is evacuated to 10⁻⁷ Torr by turbopumps 106 independently installed from the pump for the vacuum chamber.

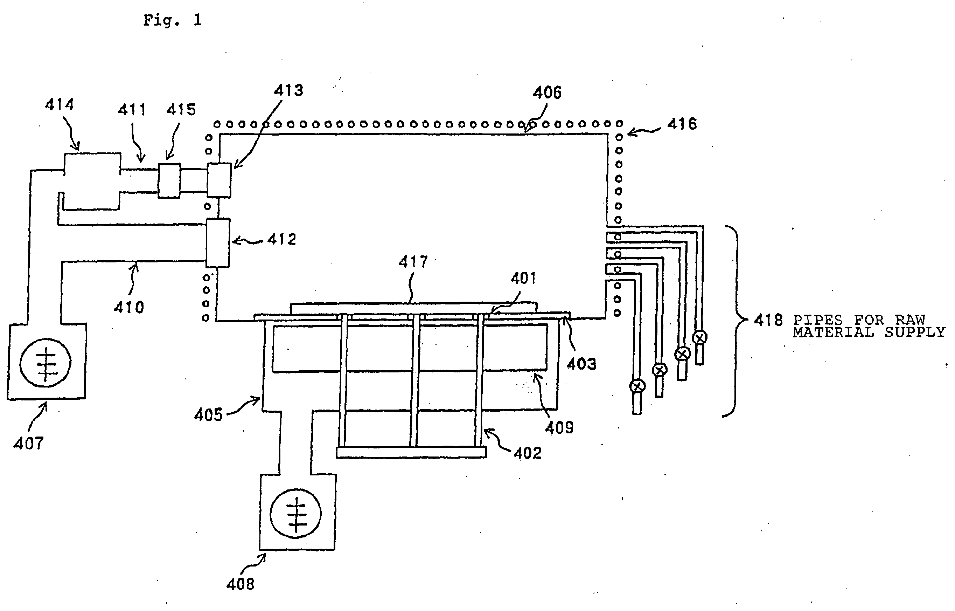

A schematic diagram showing a part of the cross-section of the vacuum chamber is illustrated in Fig. 1. The vacuum chamber 406 is equipped with a heater denoted with 416 and made of aluminum to be heated to a prescribed temperature. The material of the vacuum chamber 406 is preferable to have a high thermal conductivity and, for example, aluminum and a stainless steel may be employed. Especially, aluminum, which has a high thermal conductivity, is preferable and by using aluminum, the inner walls of the vacuum chamber can evenly be heated.

Wafers 417 are so set on a susceptor 403 made of quartz as to keep the faces to be subjected to device formation upward. Three holes 401 with 5 mm diameter are formed in the susceptor 403 made of quartz and pins 402 made of quartz are moved up and down through the holes to mount wafers on the susceptor 403 from the transferring apparatus. After the wafers are mounted on the susceptor made of quartz, the holes for the pins are closed by the wafers themselves. The susceptor is so put on projections projected from a wall of a vacuum chamber made of aluminum as to overlap the rim parts on the projections and in the state in which the wafers are mounted on the susceptor made of quartz, the heater chamber 405, a lower part of the wafers, and the vacuum chamber 406, an upper part, into which film growth gases are to be introduced are separated.

The inner walls of the vacuum chamber 406 are preferable to be set at a temperature by the foregoing heater 416 (wall heating means) not lower than a temperature at which organometal gases can have sufficiently high vapor pressures and not higher than organometal gas decomposition temperature. That is, since organometal gases include several kinds of raw materials, the composition ratio of organometal gases reacting on the wafer could be unbalanced owing to that a part or all of the organometal gases are liquefied or solidified or that organometal gases are decomposed, so that the temperature is preferable to be controlled not lower than the temperature at which the organometal gases have sufficiently high dissociation speed without being condensed in the inner wall and lower than the decomposition temperature of the organometal gases. Consequently, since the organometal materials and their decomposed products hardly adhere to the walls, generation of particles formed by peeling of the adhering substances can be prevented.

In the present invention, it is preferable to coat the inner walls of the vacuum chamber with aluminum oxide since the coating is effective to further suppress the number of particles generated. The thickness of the aluminum oxide is required to be thick enough to eliminate pin holes and preferably, for example, 1 µm or thicker, more preferably 3 µm or thicker, and furthermore preferably 5 µm or thicker. Nevertheless, it is ineffective to be too thick to suppress particle generation, so that 10 µm thickness is sufficient, however there is no problem to be thicker than that. It is necessary for aluminum oxide to be formed firmly on the surface as to avoid separation and it is especially preferable to form aluminum oxide by sintering. Incidentally, the thickness of aluminum oxide which is formed by natural oxidation on the aluminum metal surface is insufficient.

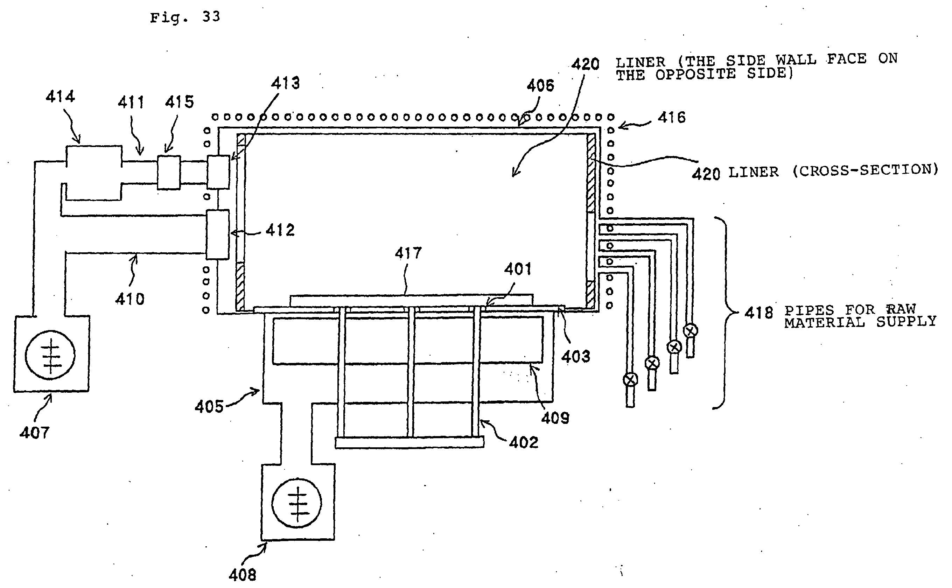

In the present invention, though the inner walls of the vacuum chamber may be coated directly with aluminum oxide just as described above, a liner 420 on whose surface aluminum oxide is formed may be disposed on the inner wall faces of the vacuum chamber just as illustrated in Fig. 33. In the case of using such a liner, replacement is made easy, so that the particle generation can further be suppressed by replacing the liner when adhering substances, which are particle generation sources, adhere to the liner.

In this case, the liner may be disposed in all of the inner walls of a vacuum chamber besides a vacuum exhaust port and introduction ports of pipes. Alternatively, the liner may be disposed only in the parts where adhering substances exist especially much and the wall surfaces of parts where no liner is disposed may be coated with aluminum oxide. Further, aluminum oxide may be formed previously in the inner walls of a vacuum chamber and further a liner may be disposed on the surfaces coated with aluminum oxide. Incidentally, that a liner is disposed in the inner walls of a vacuum chamber means a liner is placed in close contact with the inner walls of the vacuum chamber to a certain extent. But it is not necessarily required to be attached perfectly closely to the inner wall to cover the walls.

The material for the liner may be, for example, quartz and aluminum. Since the structure of Fig. 33 is same as that of Fig. 1 except the liner, the description is omitted.

The vacuum chamber 406 and the heater chamber 405 are evacuated by separate turbo molecular pumps 407, 408 and with such a structure, the leakage of organometal gases and an oxidizing gas to the heater chamber can be suppressed.. Especially, in the case of this growth method using an oxidizing gas, oxidation of the heating mechanism 409 installed in the heater chamber to heat wafers can be prevented and thus the life of the heating mechanism 409 can significantly be prolonged. Such a structure is also effective to prevent short circuit and to prevent unevenness of the substrate temperature caused by adhesion of raw material gases on the heating mechanism. The pressure of the heater chamber during the film formation was 1 × 10⁻⁶ Torr when the pressure of a vacuum chamber was 1 × 10⁻³ Torr and the pressure difference of about three figures was obtained.

When the temperature of a heater for heating wafers is increased, the temperature of a susceptor made of quartz is also increased to cause adhesion of organometal gases thereon, however by coating the surface of quartz with a metal oxide (a high temperature part-coating dielectric material) of such as STO (strontium titanate: SrTiO₃), the parting of adhering substances of organometal gases can be suppressed and as a result, contamination with particles can be prevented. As the high temperature part-coating dielectric material, the preferable compounds are, besides STO, PTO (lead titanate: PbTiO₃), BTO (barium titanate: BaTiO₃), PLZT {(Pb, La)(Zr, Ti)O₃}, PNbZT {(Pb, Nb)(Zr, Ti)O₃}, SBT (SrBi₂TaO₉), Pb(Zr, Ti)O₃, (Ba, Sr)TiO₃, and the likes.

In the case a metal oxide dielectric material to be grown and a high temperature part-coating dielectric material are different, materials with the same crystal system (crystal structure) or similar crystal system to the system are preferably selected. For example, in the case of growing a perovskite type material, a perovskite type material is preferable to be used as the high temperature part-coating dielectric material. In the case of growing a metal oxide dielectric material with a layered structure such as SrBi₂Ta₂O₉, a material having a layered structure is preferable to be used as the high temperature part-coating dielectric material.

As the high temperature part-coating dielectric material to be used in this case, the materials as described above may be used and further preferable materials are those which can firmly adhere to the material of a susceptor and have similar crystal system to that of a metal oxide dielectric film to be grown and are possible to form coatings by sintering. For example, STO can firmly adhere to quartz by sintering. Since PZT, the material to be grown, is a ceramic having the same crystal system as STO, the PZT is very difficult- to be parted and particle generation scarcely takes place.

Though this embodiment is described as the case of employing quartz as the material of a susceptor, besides quartz, SiC, Si, BN, or the like may be used and a high temperature part-coating dielectric material such as STO, BTO, PTO, PZT, BST, or the like can be sintered to form a coating on the surface.

In the case a silicon wafer is used as a substrate, using Si as the material of a susceptor is preferable since temperature is easily made even in the wafer. For example, as silicon oxide film is formed on the surface of a silicon plate by thermal oxidation or the like and further STO is sintered on the resultant surface to obtain a susceptor made of silicon coated with a high temperature part-coating dielectric material.

In the present invention, it is satisfactory to coat the surface of a susceptor with a high temperature part-coating dielectric material as described above, and of course, it is similarly effective that the whole body of the susceptor is made of such a material.

Two lines, a main exhaust line 410 and a sub exhaust line 411, are connected to an exhaust port of a vacuum chamber and the main exhaust line is connected to a turbo pump 407 through a main gate valve 412. The sub exhaust line 411 is connected to the turbo pump 407 through a valve 413 and then a water cooling trap 414. During the film formation, the main gate valve 412 is closed and the valve 413 is opened to discharge exhaust gases through the sub exhaust line 411. With such a constitution, solidification and liquefaction of organometal gases in the turbo pump 407 can be avoided and the life of the turbo pump 407 can be prolonged. Additionally, the total pressure of raw material gases in the vacuum chamber can be changed by introducing a valve 415 capable of adjusting conductance between the sub exhaust line 411 and the water cooling trap 414 and adjusting the conductance. At the time when no raw material gas is supplied, the exhaust speed can be heightened by opening also the main gate valve 412 to effectively maintain high vacuum degree. Further, these valves are effective to sharply decrease the partial pressure of each organometal gases in the vacuum chamber. The main gate valve 412 and the valve 413 are buried in an aluminum vacuum chamber 406 and enabled to be evenly heated.

In this apparatus, though a turbo molecular pump is employed for a pump for exhaust, a mechanical booster pump, a dry pump, a rotary pump, or the like may be usable and it is required to plan the exhaust capability of the pump and conductance of the valves and the water cooling trap as to decrease the inner pressure of the vacuum chamber to 1 × 10⁻² Torr or lower.

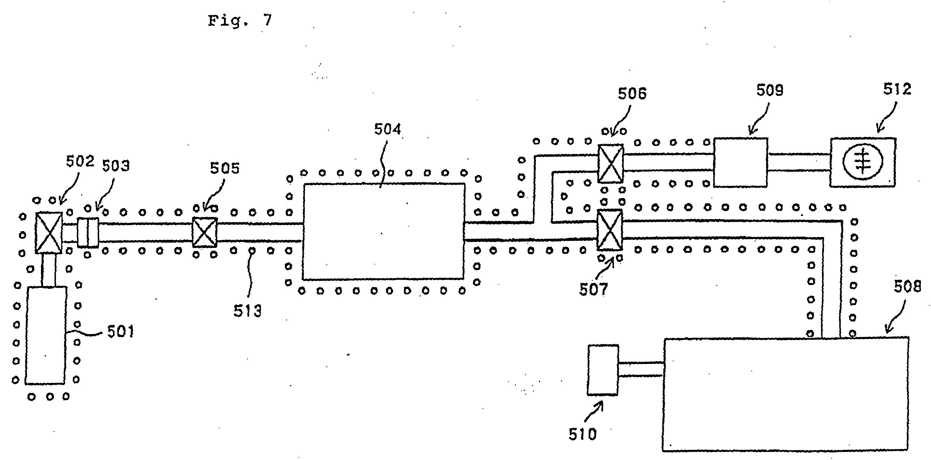

A schematic diagram of a part of a raw material supply system is illustrated in Fig. 7. An organometal gas is a solid or a liquid at a room temperature and stored in a cylinder 501. The cylinder 501 is equipped with a valve 502 installed above and enabled to be parted from a flange 503 between the valve 502 and the supply system to exchange raw materials. Each organometal gas is extremely easily oxidized, so that the organometal gas is preferable to be kept no contact with atmospheric air. If being exposed to atmospheric air, the organometal gas is oxidized, a metal oxide is formed, the pipes are clogged, and a mass flow controller 504 is clogged. Incidentally, the cylinder 501 is enabled to be heated also by a heating means 513 and is heated to the extent where the vapor pressure of each organometal material housed in the cylinder is high enough to operate the mass flow controller.

Organometal gases include those in a liquid state and those in a solid state at a normal temperature and normal pressure and the liquid raw materials are poured in cylinders as they are. On the other hand, solid raw materials are preferable to be deposited on the surface of alumina with about 1 mm diameter. By using such raw materials, gases can be generated stably at the time of heating. The purity of the generated gases is high. The heating temperature of a cylinder is set to be a temperature high enough to obtain a sufficiently high vapor pressure to operate the mass flow controller.

A pipe from the cylinder 501 is connected to the mass flow controller 504 through a stop valve 505 and thereafter divided into two pipes equipped with stop valves 506, 507, respectively, and connected to a vacuum chamber 508 and to a pump 512 via a water cooling trap 509, respectively. Parts of the raw material supply system comprising these pipes, the mass flow controller 504, valves 502, 505, 506, 507, and the likes and which are to be brought into contact with organometal gases are provided with heating means 513 and as same as the inner walls of the foregoing vacuum chamber, they are kept at a temperature not lower than the temperature at which the organometal gases are liquefied or solidified and not higher than the decomposition temperature of each organometal gas.

The cylinder 501 is also enabled to be heated by the heating means 513 and heated to the extent where the vapor pressure of each organometal material housed in the cylinder is high enough to operate the mass flow controller.

In an apparatus to be employed for the present invention, the flow rate of each raw material gas is adjusted by a mass flow controller and that is because it is preferable to directly control the flow rate of each raw material gas without using a carrier gas and from that point of view, flow rate control is not limited to that by a mass flow controller.

At the time of film formation, at first the valve 502, 505, 506 are opened to operate the mass flow controller 504 by the spontaneous pressure of an organometal gas in the cylinder 501 and a gas is evacuated by the pump 512 to stabilize the gas flow rate in the mass flow controller 504 during the time. Next, the valve 506 is closed and the valve 507 is opened, so that the organometal gas whose flow rate is precisely controlled can be supplied to the vacuum chamber.

It is preferable for a vapor phase growth apparatus of the present invention to be provided with one series of the supply system as illustrated in the Fig. 7 for each organometal gas. Further, an exclusively separate pipe is preferable to be installed for an oxidizing gas.

In this embodiment, each of organometal gases and an oxidizing gas is introduced into a vacuum chamber through independent raw material supply pipes 418 (Fig. 1) and then mixed to one another in the vacuum chamber. That is, the apparatus is so composed as to keep separated of the organometal gases and the oxidizing gas from each other before they are introduced into the vacuum chamber. The reason for that is, because if the organometal gases and the oxidizing gas are brought into contact with each other, the organometal gases are oxidized and metal oxides are generated to cause clogging of the pipes and clogging of the mass flow controller and further because the metal oxides are sent to the vacuum chamber to result in generation of particles and inhibition of thin film formation with excellent crystallinity at low temperature.

The partial pressure of each organometal gas in the vacuum chamber is determined by the supply amount of each gas, the amount consumed on the substrate and the susceptor, the exhaust amount, and the adhesion amount to the walls of the vacuum chamber. If the temperature of the walls of the vacuum chamber is kept at a proper temperature to keep a sufficiently high vapor pressure of each organometal gas and to inhibit decomposition of each organometal gas, the decrease owing to the adhesion of the raw material gases to the inner walls of the vacuum chamber can be neglectable. Further since the raw material gas amount consumed on the substrate and the susceptor is as low as about 1/1000 of the supply amount, the pressure of the vacuum chamber is determined by the gas supply amount and the exhaust amount. A vacuum gauge 510 for monitoring the pressure is installed in the vacuum chamber. Incidentally, the foregoing parts which are to be brought into contact with organometal gases are required to be parts having sufficiently high heat resistance to the temperature at which at least organometal gases can have sufficient vapor pressure.

By providing an apparatus with the above described apparatus constitution, only organometal gases and an oxidizing gas necessary for film formation can be introduced into the vacuum chamber to actualize the film formation conditions of the present invention. That is, an oxidizing gas and each organometal gas can be introduced into the vacuum chamber through separate introduction ports and the pressure can be controlled to keep the inner pressure of the vacuum chamber at 1 × 10⁻² Torr or lower. The pressure of the vacuum chamber may be changed and adjusted to be at a desired value by adjusting the exhaust amount of the sub exhaust line 411 and the flow rate of the mass flow controller. Further, by adjusting the temperature of the heater 416 to be at a prescribed temperature, it is made possible to control the temperature of the inner walls of the vacuum chamber not lower than the temperature at which the organometal gases have sufficiently high vapor pressure and lower than the decomposition temperature of the organometal gases. In this apparatus example, aluminum, which is a material having a high thermal conductivity, is used as a material for the vacuum chamber and if the temperature to provide sufficient vapor pressure of organometal gases exceeds 200°C, a stainless steel may be employed.

Further, since the mass flow controller is operated by the spontaneous pressure of raw material gases and the likes to introduce organometal gases and the oxidizing gas into the vacuum chamber, not like a conventional method, raw materials can be transported without using a carrier gas.

In a method for vapor phase growth on a capacitor electrode using organometal gases, nitrogen dioxide may be used as the oxidizing gas. Nitrogen dioxide may be passed through a pipe for the oxidizing gas.

The total pressure of the vacuum chamber during the film formation can be kept at 1 × 10⁻² Torr or lower by controlling the exhaust amount of the sub exhaust line 411 (Fig. 1) and the flow rate of the mass flow controller 504 (Fig. 5).

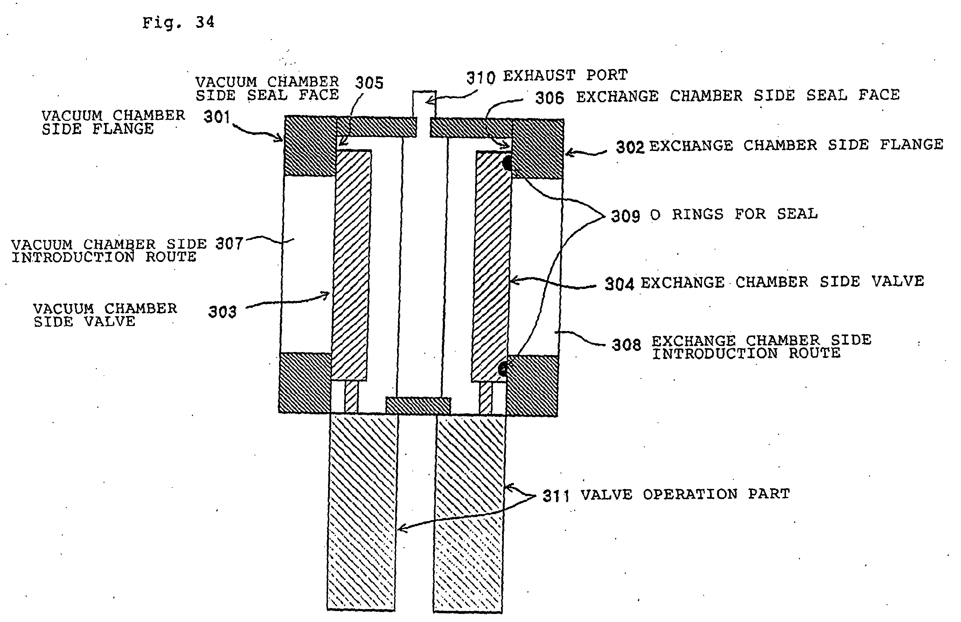

Next, a preferable embodiment of double gate valves 104 (Fig. 6) to be employed for a vapor phase growth apparatus of the present invention will be described further in detail with the reference to Fig. 34. As illustrated in the Fig., double gate valves are separately connected to a vacuum chamber and an exchange chamber through the vacuum chamber side flange 301 and the exchange chamber side flange 302, respectively. In the vacuum chamber side, in the close state, the vacuum chamber side introduction route 307 is closed by contacting the vacuum chamber side valve 303 and the vacuum chamber side seal face 305 to each other. In the seal part, no O ring is employed and the metal faces are allowed to be contacted to each other. In the case of setting in the open state, the vacuum chamber side valve 303 is moved, for example, in the vertical direction to the plane of the Fig. by the valve operation part 311 to release the vacuum chamber side introduction route 307.

In the exchange chamber side, in the close state, the exchange chamber side introduction route 308 is closed by contacting the exchange chamber side valve 304 and the exchange chamber side seal face 306 to each other through O rings 309 for seal. Meanwhile in the open state, the exchange chamber side introduction route 308 is opened by moving the exchange chamber side valve 304 by the valve operation part 311.

Further, the inside of the double gate valves is evacuated through the exhaust port 310 and kept vacuum. When a substrate is put in and taken out between the vacuum chamber and the exchange chamber, both of the vacuum chamber side valve and the exchange chamber side valve are opened and during the film formation in the vacuum chamber, both of the vacuum chamber side valve and the exchange chamber side valve are closed. By employing such a double gate valve structure, the following advantageous points can be provided. At first, it is made possible to suppress leakage of atmospheric- air to the vacuum chamber at the time when the exchange chamber is released to the atmospheric air for wafer replacement. Also, it is made easy to keep high vacuum degree since no raw material adheres to the valve seal face in the exchange chamber side.

Further, in the vacuum chamber side, metals are brought into contact with each other in the close state and there is no part to be deteriorated by heating to a high temperature, so that the temperature of the vacuum chamber can be set freely. If O rings are employed, in the case a common O ring material is used, they are deteriorated by heating to, for example, around 180°C and it occurs a problem that the deteriorated material possibly becomes a particle generation source. On the other hand, since the exchange side valve is remote from the vacuum chamber at a high temperature, even if O rings are used, the O rings are not deteriorated and do not generate particles and the vacuum degree can sufficiently be maintained by the O rings.

Described above is an example of employing double gate valves of the exchange chamber side valve, which is a general gate valve, and the vacuum chamber side valve, which is a gate valve with no O ring. However, the vacuum chamber side valve is not restricted to such a valve as long as it can shield the exchange chamber side valve from raw material gases. That is, it may be sufficient to install a movable shielding plate capable of shielding the flow of the raw material gases from the vacuum chamber side as to avoid direct adhesion of the raw material gases to a gate valve and such a movable shielding plate is sufficiently usable for practical use even if it does not have a completely closable property. Further, in order to prevent adhesion of the raw material gases, the movable shielding plate is preferably set at a temperature not lower than a temperature at which the organometal gases can have sufficiently high vapor pressure and not higher than a decomposition temperature of the organometal gases.

Next, an embodiment of a film formation method of the present invention will be described while exemplifying film formation of a PZT film, for example.

Representative raw materials, raw material temperature, and temperature of a mass flow controller in the case of PZT film formation are as follows: as a Pb raw material, lead bis(dipivaloylmethanate) Pb(DPM)₂, raw material temperature 177°C, temperature of a mass flow controller 200°C; as a Zr raw material, tetra(tert-butoxy) zirconium Zr(OtBu)₄, raw material temperature 70° C, temperature of a mass flow controller 110°C; as a Ti raw material, tetra(isopropoxy) titanium Ti(OiPr)₄, raw material temperature 75°C, temperature of a mass flow controller 145°C; the mass flow temperature of NO₂ 145°C; and the temperature of the inner walls of the vacuum chamber 180°C.

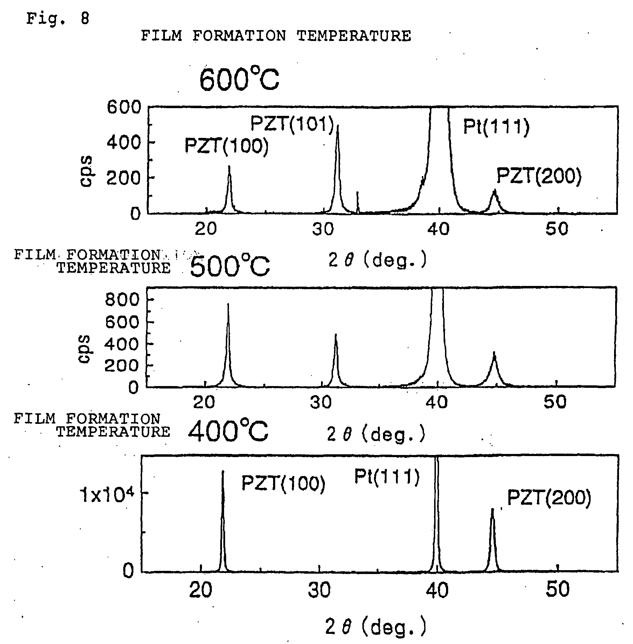

X-ray diffraction spectra of PZT in the case of keeping the film formation conditions constant and changing the film formation temperature are shown in Figs. 8. Silicon wafers employed for substrates were those produced by forming a 500 nm thick silicon oxide film on silicon wafers and then forming a 200 nm thick Pt film by a sputtering method. The film formation conditions were controlled as follows: film formation was carried out at first for 40 seconds in the conditions of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂, and then film formation was carried out for 600 seconds in the conditions of 0.25 SCCM flow rate of Pb(DAM)₂, 0.225 SCCM flow rate of Zr(OtBu)₄, 0.2 SCCM flow rate of Ti(OiPr)₄, and 3.0 SCCM flow rate of NO₂. The total pressure of the gases in a vacuum chamber during the film growth was controlled to be 5 × 10⁻³ Torr.

As being understood from Figs. 8, x-ray diffraction peak attributed to PZT with the perovskite type crystal structure were observed at 400°C substrate temperature. Though being not shown in Figs. 8, no peak attributed to PZT was observed at all at 350°C substrate temperature and it was found that the film was in amorphous state. In the present invention, film formation is preferable to be carried out at 360°C or higher and, for example, at 380°C, a PZT film with sufficiently evenly oriented crystal structure was obtained. In this Figs., the x-ray diffraction spectra obtained in the case of employing film formation temperature at three levels; 400°C, 500°C, and 600°C were compared to one another. As being shown in the Figs., in a high temperature region of 500°C or higher, two kinds of peaks of (100) and (101) were observed, whereas in a low temperature region of around 400°C, only one kind peak of (100) was observed, implying that to form a film at a low temperature was effective to obtain a film with extremely even crystallization direction and with a highly oriented perovskite type crystal structure. Also in the case of forming a film at a temperature lower than 400°C, as long as the temperature was high enough to form a perovskite type crystal structure, the patterns of the x-ray diffraction spectra of the resultant films were same as those of films formed at 400°C and only one kind peak of (100) was observed to find that films formed had extremely even crystallization direction and with a highly oriented perovskite type crystal structure.

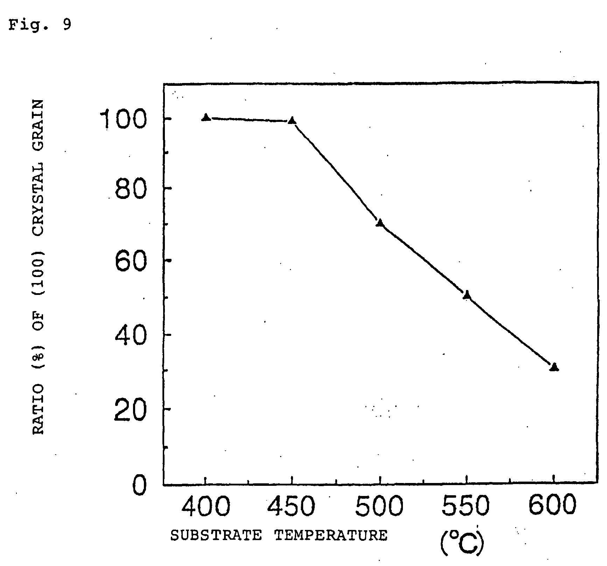

Fig. 9 shows the alteration of the ratio of crystal grains whose crystal axes in the perpendicular direction to a substrate was (100) in polycrystalline PZT computed from the x-ray diffraction spectra in the case of changing the film formation temperature. From Fig. 7, it was found that films so highly oriented as to orient all of the crystal grains to the (100) direction were obtained by controlling the film formation temperature at 450°C or lower. At 450°C or higher, crystal grains oriented in the (101) or (111) direction were formed to find the orientation property was deteriorated.

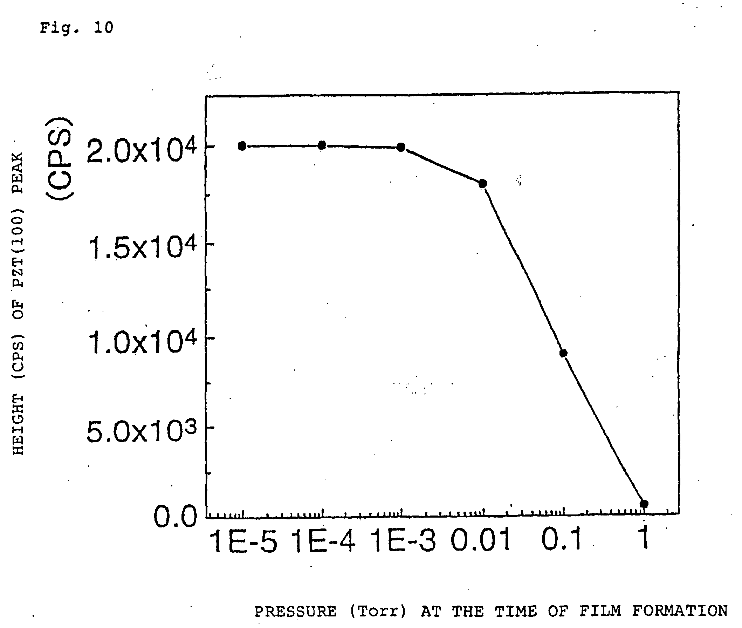

The crystallization temperature as shown has noticeable total pressure dependency. In Fig. 10, the alteration of the height of the PZT (100) peak appearing in the x-ray diffraction spectra in the case of changing the total pressure without changing the ratio of the partial pressure of each organometal gas by adjusting the conductance valve 415 installed in the foregoing sub exhaust line while keeping the substrate temperature at 400°C. Silicon wafers employed for substrates were those produced by forming a 500 nm thick silicon oxide film on silicon wafers and then forming a 200 nm thick Pt film by a sputtering method. The film formation conditions were controlled as follows: film formation was carried out at first for 40 seconds in the conditions of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂, and then film formation was further carried out until the film thickness became 100 nm in the conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂. The thickness of the grown film was 100 nm in this case. When the total pressure of the gases was higher than 10⁻² Torr, the height of the PZT(100) peak was found sharply decreasing. That shows if the total pressure is higher than 10⁻² Torr, the crystal structure becomes deteriorated from the perovskite type crystal structure of PZT (100) with desired orientation property. In a high pressure region of the total pressure higher than 10⁻² Torr, peaks attributed to PbO, TiO₂, and ZrO₂ are observed in x-ray diffraction spectra.

The reason why the crystallinity is better as the pressure in a vacuum chamber is decreased more at the time of film formation is based on the following principle. When the total pressure is increased, organometal gas molecules supplied to a growth chamber repeat collision to an oxidizing gas such as nitrogen dioxide many times before they reach a substrate and decomposed by reaction to form metal oxides such as PbO, TiO₂, ZrO₂ in vapor phase. Further, these metal oxides repeat collision to one another to form microcrystals of their mixtures before they reach the substrate. These microcrystals are not controlled in the compositions and the film formation temperature, so that the microcrystals cannot become the perovskite type crystal structure. If these microcrystals adhere to the substrate, crystal growth with crystal structure different from the perovskite type crystal structure starts using these microcrystals as crystal nuclei. Consequently, the crystallinity after the film formation is deteriorated. In order to rearrange theses crystallines to form a perovskite type metal oxide dielectric film, the temperature has to be raised to 650°C or higher. Since the foregoing reaction more hardly occurs as the pressure of the vacuum chamber is decreased more at the time of film formation, the crystallinity can be improved. However, in order to form microcrystals of mixtures, collision is required to be repeated a plurality of times and according to the foregoing experiments, if the film formation is carried out at a pressure not higher than 10⁻² Torr, reaction of an oxidizing gas and organometal gases does not take place and decomposition of the gases occurs only on the surface of a substrate and as a result, a film with excellent crystallinity can be obtained at a low temperature.

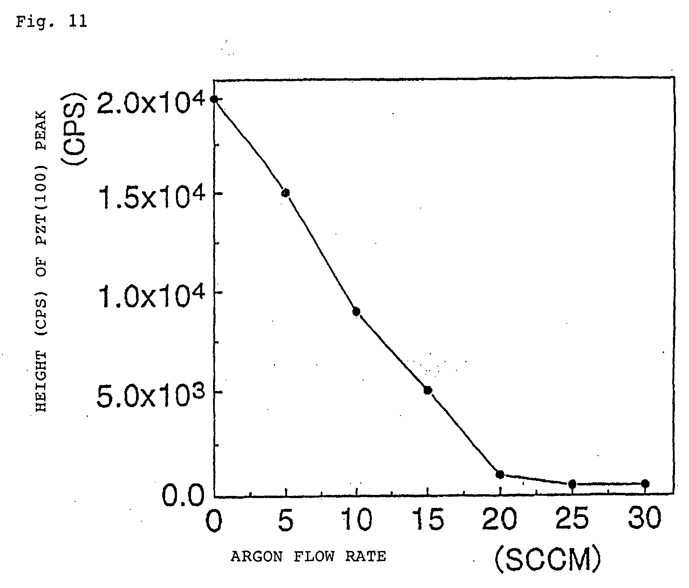

Fig. 11 shows the alteration of the height of the PZT (100) peak appearing in the x-ray diffraction spectra in the case of keeping the substrate temperature at 400°C and introducing argon into a vacuum chamber and changing the introduction quantity of argon without changing the flow rate of each organometal gas and the exhaust rate. Silicon wafers employed for substrates were those produced by forming a 500 nm thick silicon oxide film on silicon wafers and then forming a 200 nm thick Pt film by a sputtering method. The film formation conditions were controlled as follows: film formation was carried out at first for 40 seconds in the conditions of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂, and then film formation was carried out for 600 seconds in the conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂. The total pressure of the gases in a vacuum chamber during the film growth was controlled to be 5 × 10⁻³ Torr. The formed film thickness was 100 nm at that time. It was found that in the case the introduction amount of argon was much, the PZT(100) peak was low and that if the introduction amount of argon was decreased, the PZT(100) peak was increased. This is also observed in the same manner in the case of introducing a gas to be used as a carrier gas irrelevant to film growth such as nitrogen and helium. Therefore, it is found effective to avoid simultaneous introduction of such carrier gases in order to obtain excellent crystals at a low temperature.

The present invention is also significantly effective to improve property deterioration at the time of making a film thin. That is based on the following principle. By a conventional method such as a sol-gel method or the like, crystallization is caused by heating at a temperature as high as 600°C or higher. At that time, metals of a metal oxide dielectric film are alloyed with an electrode metal and diffused in the electrode metal. For example, in the case of PZT, Pb is diffused into the electrode, so that lead voids where Pb is deficient are formed in the vicinity of the interface. Such a part where a part of metals is lessened is called as a transition layer. The transition layer is a film as thin as about 1,000 Å or thinner and in a region of about several thousand Å or less in the thickness direction including the transition layer, the composition differs from the stoichiometric ratio and the orientation is inferior to result in inferior electric properties. In the case where a film is made thin, the ratio of the transition layer in the film increases to result in deterioration of properties. However, in this method of the present invention, since film formation is carried out at 450°C or less, such a transition layer is scarcely formed and deterioration of the properties in the case of thinning a film is scarce.

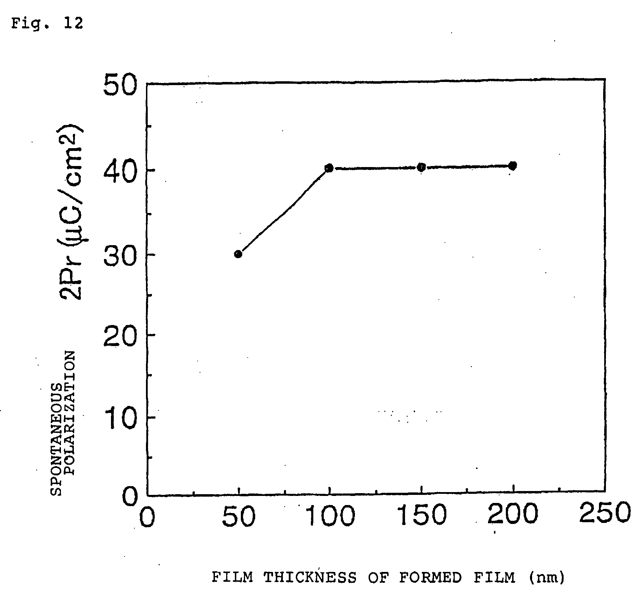

Fig. 12 shows the dependency of the spontaneous polarization on the film thickness, where PZT film formation was conducted by a vapor phase growth method of the present invention. Silicon wafers employed for substrates were those produced by forming a 500 nm thick silicon oxide film on silicon wafers and then forming a 200 nm thick Pt film by a sputtering method. The film formation conditions were controlled as follows: film formation was carried out at first for 40 seconds in the conditions of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂, and then film formation was carried out for 600 seconds in the conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂. The total pressure of the gases in a vacuum chamber during the film growth was controlled to be 5 × 10⁻³ Torr. The obtained film thickness in this case was 100 nm. As compared with results of spontaneous polarization of a dielectric film formed by a sol-gel method as shown in Fig. 3, it was found that the spontaneous polarization value did not decrease even in the case of thin films. The similarly improvement effect was confirmed in suppression of specific dielectric constant in a high-dielectric-constant film of such as BST.

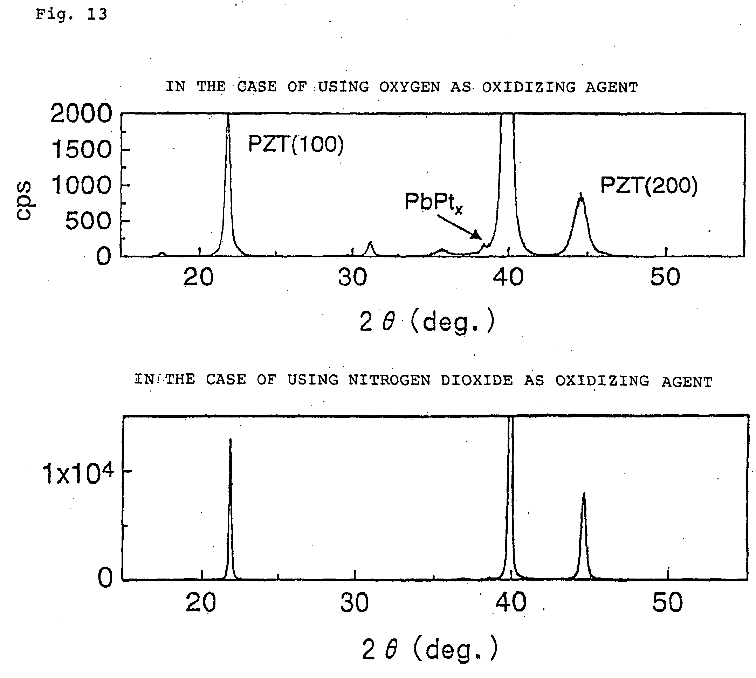

By using nitrogen dioxide as an oxidizing gas, the oxidizing force of the oxidizing agent is improved during the film formation and the properties of a film can be further improved. Figs. 13 shows the comparison of x-ray diffraction spectra of the cases of using O₂ and NO₂ as oxidizing agents in PZT film formation at 400°C substrate temperature and in the same conditions. The flow rates of O₂ and NO₂ were so controlled as to keep the total pressure 5 × 10⁻³ Torr or less and kept at the same flow rate. As being understood according to the Figs. 13, though PZT crystal was formed in both cases, in the case of using O₂, the PZT(100) peak value was low and the crystallinity was inferior. Also in the case of using O₂, a peak attributed to PbPtₓ, which was an alloy of Pt and Pb, appeared in the low angle side of Pt and that was supposedly attributed to that Pb was insufficiently oxidized and metal Pb was deposited and alloyed with Pt. According to the results of investigation of the compositions of specimens by fluorescence x-ray analysis, it was found that owing to the alloying with Pt, Pb was deficient and also that oxygen amount was low. In the case of supplying ozone as an oxidizing agent from an ozone generating apparatus installed in the outside of the apparatus or further same in the case of installing a plasma source of such as ECR in the film formation chamber to dissociate oxygen in plasma and supply oxygen radial or oxygen ion as an oxidizing agent, it was found that the oxidizing force was improved as compared with that in the case of supplying oxygen molecule, alloying reaction with Pt was suppressed, and the oxygen deficiency in a resultant film could be suppressed.

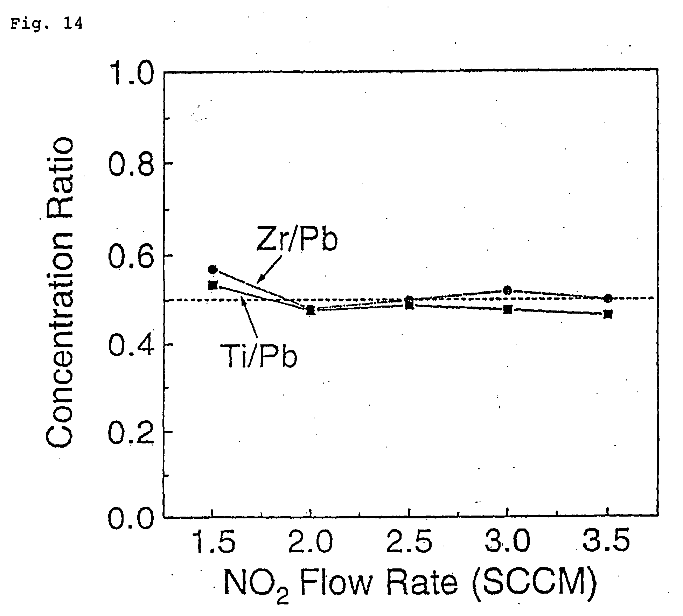

Fig. 14 shows the alteration of the composition ratios of Zr/Pb, Ti/Pb in the case of altering the flow rate of NO₂ while keeping the flow rates of organometal gases of Pb, Zr, and Ti constant. That is, as film formation conditions, the substrate temperature was set at 400°C and film formation was carried out at first for 40 seconds in the conditions of 0.2 SCCM flow rate of Pb(DPM)₂, 0.05 SCCM flow rate of Zr(OtBu)₄, 0.25 SCCM flow rate of Ti(OiPr)₄, and flow rate of NO₂ changed to be the flow rate as shown in Fig. 14 and then film formation was further carried out for 600 seconds in the conditions of 0.25 SCCM flow rate of Pb(DPM)₂, 0.225 SCCM flow rate of Zr(OtBu)₄, 0.2 SCCM flow rate of Ti(OiPr)₄, and flow rate of NO₂ changed to be the flow rate as shown in Fig. 14. The total pressure of the gases in the vacuum chamber during the film formation was controlled to be 5 × 10⁻³ Torr. At 2 SCCM or higher NO₂ flow rate, the resultant compositions were found well conformed to the stoichiometric ratio and perovskite type crystals with even orientation were found produced. At 1.5 SCCM or lower flow rate of NO₂, Ti/Pb, Zr/Pb increased and it was found that the crystal structure was slightly deteriorated. That was attributed to that since the oxidizing force to Pb was insufficient at 1.5 SCCM or lower flow rate of NO₂, the deposition of metal Pb and subsequent alloying with Pt took place so that Pb was removed from the films. The total pressure in the vacuum chamber at that time was 1 × 10⁻⁴ Torr. It is, therefore, preferable to carry out film formation in a range of flow rates of an oxidizing gas to provide sufficient oxidizing force.

As described above, NO₂ has high oxidizing force to Pb, and as compared with O₂, since the supply amount can be decreased, NO₂ is significantly efficient for film formation in a low pressure region.

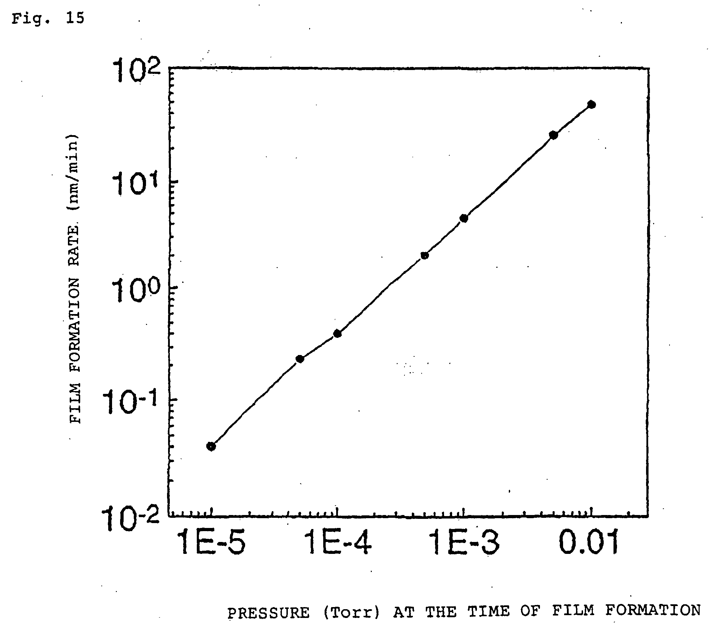

Fig. 15 shows the correlation between the total pressure and the film formation rate. The Fig. shows the PZT film formation rate in the case of changing the total pressure without changing the partial pressure of each raw material gases by adjusting the conductance valve 415 installed in the sub exhaust line 414 in Fig. 1. It was found that as the ambient gas became thinner, the film formation rate was decreased more owing to the decrease of the raw material supply amounts to the substrate surface. Being understood from this Fig., practically applicable film formation rate can be obtained if the total pressure is 1 × 10⁻⁴ Torr or higher.

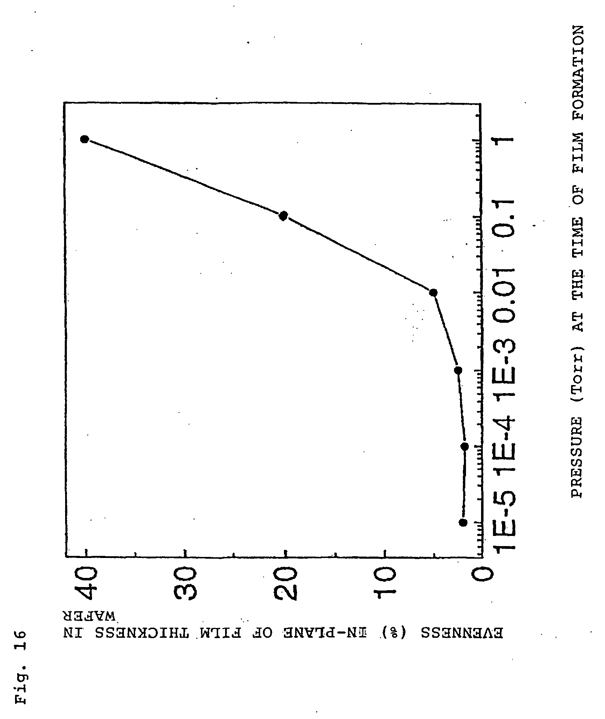

A method of the present invention can provide excellent results on the in-plane evenness of the film thickness. Fig. 16 shows the in-plane distribution of the film thickness in a 6-inch wafer in the case of changing the total pressure without changing the ratio of the partial pressure of each organometal gas by adjusting the conductance valve installed in the sub exhaust line. It was found that as the pressure was decreased, the in-plane distribution of the film thickness was improved and that such an effect was significant at 1 × 10⁻² Torr or lower. Further, the in-plane evenness of the film thickness was greatly affected with the temperature of the inner walls of the vacuum chamber.

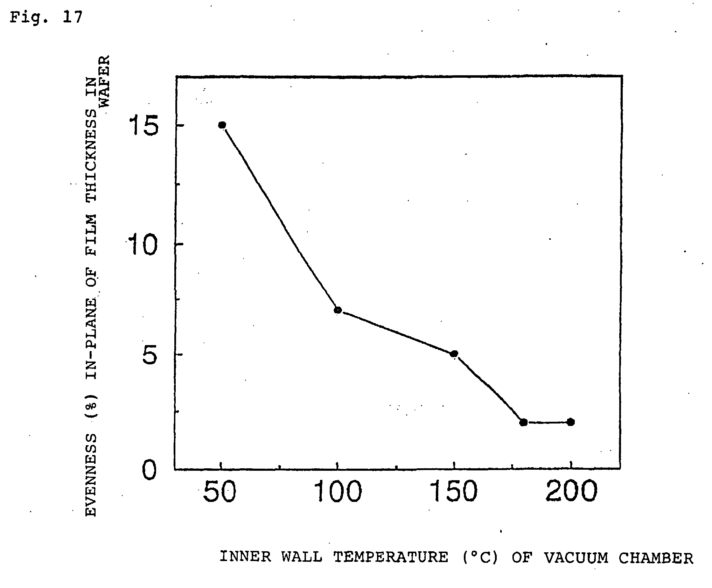

Fig. 17 shows the alteration of the in-plane distribution of the film thickness in the case of changing the temperature of the inner walls of the vacuum chamber. The increase of the temperature of the inner walls of the vacuum chamber was found effective to the improvement the in-plane distribution of the film thickness. In the case of increasing the temperature of the inner walls of the vacuum chamber to 175°C or higher, adhesion of organometal gases to the inner walls could be suppressed and the distribution of the organometal gases in the vacuum chamber became even to result in the improvement of the in-plane distribution of the film thickness.

Next, a method for controlling the composition of the present film formation will be described. As being already described with the reference to Fig. 5, self-controlling film formation method is carried out to conform the composition of A, B sites (in the case of PZT, the composition of Pb to Zr and Ti) to the stoichiometric ratio.

However, for example, in PZT film formation, the Pb raw material flow rate increase and the surface density of PbO increases, so that reaction of PbO molecules themselves takes place on the surface to result in PbO crystal formation and sharp increase of Pb composition due to the strong adhesion of PbO to PbO. In order to achieve such a self-controllability, it is required to carry out film formation at 10⁻² Torr or lower and to decompose gases on the surface. If the total pressure exceeds 10⁻² Torr, reaction is caused in the vapor-phase and microcrystals are formed and re-evaporation of PbO hardly takes place to make self-control of the composition difficult.

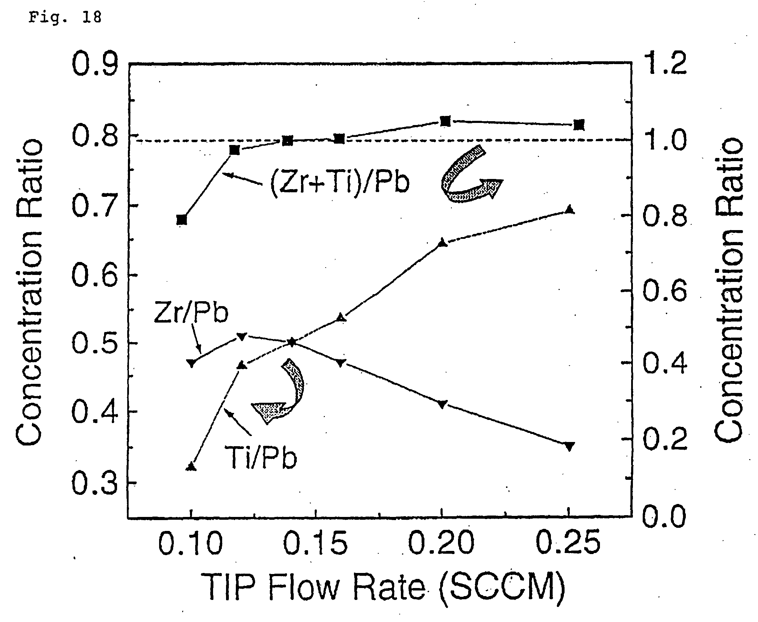

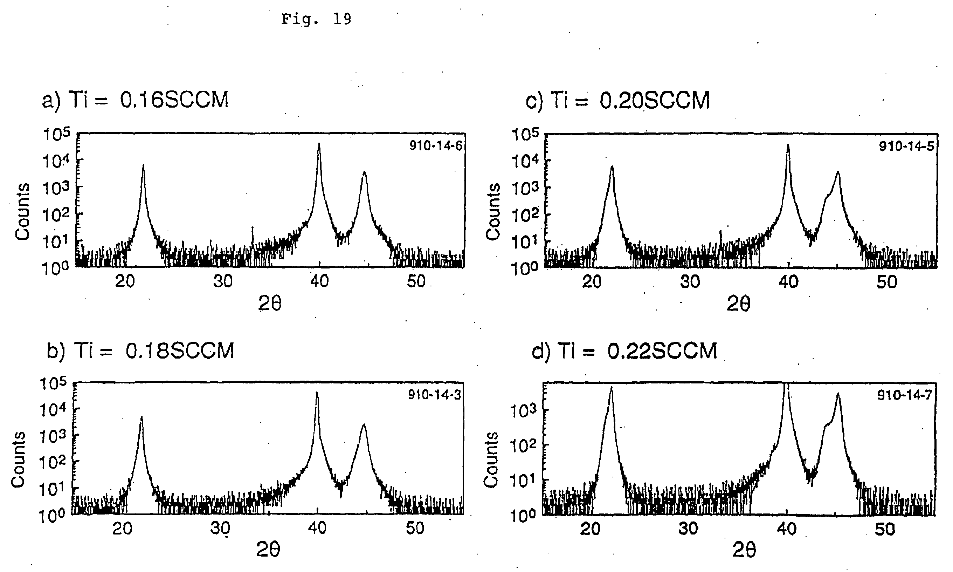

By a method of the present invention, the Ti/Zr ratio in a film was controlled by the ratio of the flow rate of organometal gases of Ti and Zr. Fig. 18 shows the alteration of the Ti/Zr composition ratio in the film in the case of changing the flow rate of the Ti raw material in film formation carried out at first for 40 seconds in the conditions of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ and then further carried out in the conditions of keeping 0.25 SCCM flow rate of Pb(DPM)₂, 0.225 SCCM flow rate of Zr(OtBu)₄, and 3.0 SCCM flow rate of NO₂ unchanged and changing the flow rate of the Ti raw material. The total pressure of the gases in a vacuum chamber during the film growth was controlled to be 5 × 10⁻³ Torr. Silicon wafers employed for substrates were those produced by forming a 500 nm thick silicon oxide film on silicon wafers and then forming a 200 nm thick Pt film by a sputtering method. The film formation duration was 600 seconds and the grown film thickness at that time was about 100 nm. The composition ratio was computed by composition analysis by fluorescence x-ray. As the Ti raw material flow rate was increased more, the Ti/Pb ratio was increased and the Zr/Pb ratio was decreased. The (Ti + Zr)/Pb ratio was thus kept constant and the A/B site ratio satisfied the stoichiometric ratio and a crystal with evenly oriented perovskite type crystal structure was found formed. Hence, it was proved that the Ti/Zr ratio in a film could be controlled by changing the ratio of the flow rates of the Ti raw material and the Zr raw material. Fig. 19 shows the alteration of the x-ray diffraction spectra of PZT in the case of changing the flow rate of the Ti raw material in film formation carried out at first for 40 seconds in the conditions of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ and then further carried out in the conditions of keeping 0.25 SCCM flow rate of Pb(DPM)₂, 0.225 SCCM flow rate of Zr(OtBu)₄, and 3.0 SCCM flow rate of NO₂ unchanged and changing the flow rate of the Ti raw material. As the Ti raw material flow rate was increased more, the difference of the (100) axis length and (001) axis length of PZT becomes wide, so that it was found that the peaks of (100), (001) and (200), (002) in the x-ray diffraction spectra tended to be separated. These results also proved that the Ti/Zr ratio could be controlled by changing the flow rates of the Ti raw material and the Zr raw material.

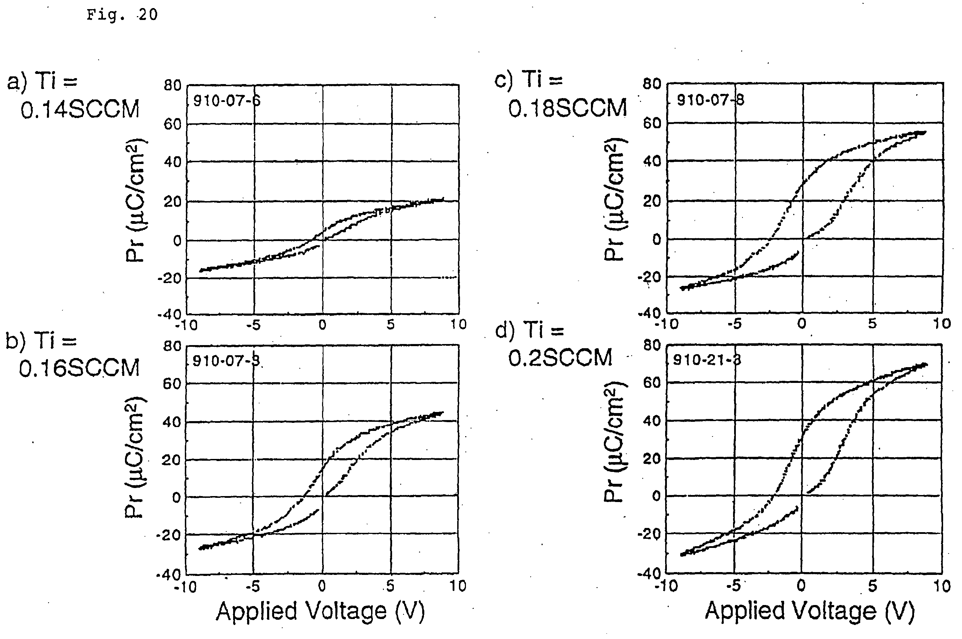

Figs. 20 show the hysteresis characteristics of PZT films formed by the same conditions. In the case of low Ti, the spontaneous polarization was a low value and as Ti was increased more, the hysteresis curves rose more and spontaneous polarization was thus found increased. In general, since with the increase of the Ti amount in a PZT film, the spontaneous polarization is increased, these results also proved that the Ti/Zr ratio could be controlled by changing the flow rates of the Ti raw material and the Zr raw material. In this invention, it was further found there was caused a significant effect to control a spontaneous polarization degree of a hysteresis curve by changing the flow rate of the Ti raw material and the Zr raw material.

A method of the present invention can improve the stepped-surface coating capability. That is because raw materials are supplied to even to the bottom of the steps owing to a convection layer of gases scarcely exists in the low pressure region.

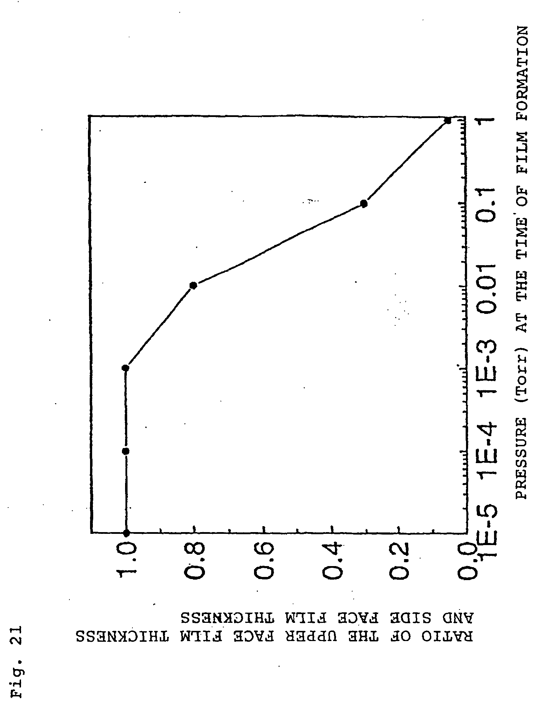

Fig. 21 shows the ratio of the film thickness of the upper face and the film thickness of the side face in the case of PZT film formation on an electrode having a step of 500 nm height and 500 nm width while changing the total pressure without changing the partial pressure of each organometal gas by adjusting the conductance valve installed in the sub exhaust line. According to Fig. 21, it was found that to decrease the total pressure to 10⁻² Torr or lower was effective to improve the stepped-face coating capability.

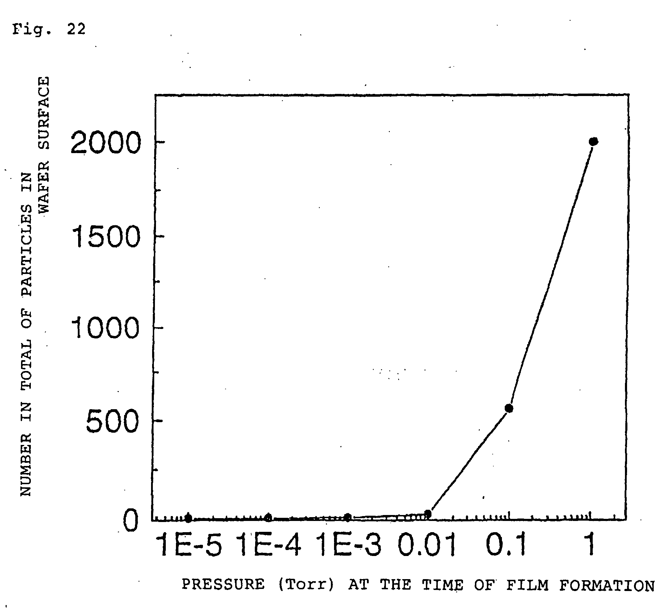

A method of the present invention was also effective to decrease particles. Fig. 22 shows the total number of particles in a 6-inch wafer in the case of continuously forming films on 1,000 wafers at 400°C substrate temperature while changing the total pressure without changing the ratio of the partial pressure of each organometal gas by adjusting the conductance valve installed in the foregoing sub exhaust line in the following conditions: at first in the conditions of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ for 40 seconds and then in the conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂ for 600 seconds. It was found that when the total pressure decreased lower than 1 × 10⁻² Torr, the number of particles was sharply decreased. That was because microcrystal nuclei were formed in the vapor phase as described above if the total pressure exceeded 1 × 10⁻² Torr and deposited on inner walls of a vacuum chamber, a susceptor or the like to result in particle formation.

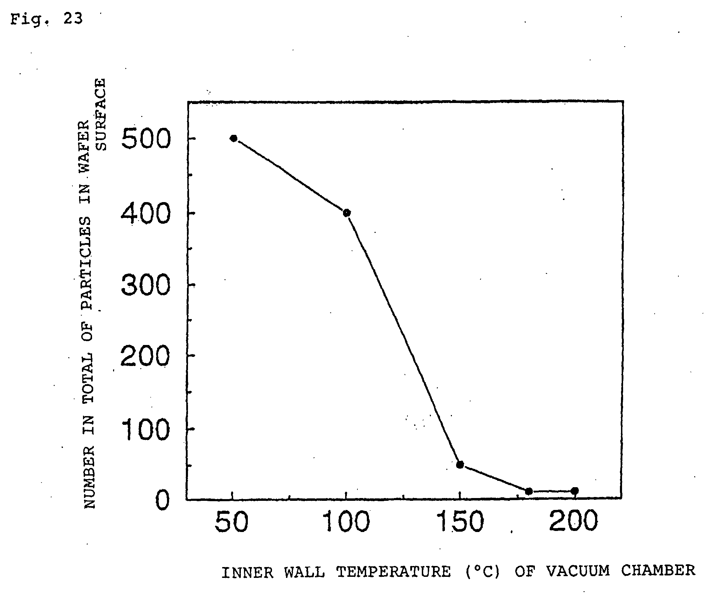

A method of the present invention is capable of further decreasing the number of the particles by setting the temperature of the inner walls of a vacuum chamber to be not lower the temperature at which the organometal gases are allowed to have a sufficiently high vapor pressure and not higher than the temperature at which the organometal gases are decomposed. Fig. 23 shows the total number of particles in a 6-inch wafer in the case of continuously forming films on 1,000 wafers at 400°C substrate temperature while changing the temperature of the inner walls of the vacuum chamber in the following conditions: at first in the conditions of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ for 40 seconds and then in the conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂ for 600 seconds. The total pressure of the gases in the vacuum chamber during the film formation was controlled to be 5 × 10⁻³ Torr. It was found that with the increase of the temperature of the inner walls of the vacuum chamber, the number of the particles tended to decrease. The number of the particles sharply decreased especially at 150°C or higher and it was found preferable to set the temperature at 175°C or higher and further preferable at 180°C or higher. Such a tendency was attributed to that if the temperature of the inner walls of the vacuum chamber was decreased, organometal gases adhered to the vacuum chamber and were parted. Nevertheless, the temperature of the inner walls of the vacuum chamber should be at highest the decomposition temperature of the organometal gases and if the temperature was increased higher than that, reaction products formed by decomposition of the organometal gases adhered to the inner walls of the vacuum chamber and were parted to result in increase of particles. Incidentally, quartz coated with STO in the surface was employed for the susceptor and the inner walls of the vacuum chamber employed was coated with aluminum oxide.

Next, in the case of forming a metal oxide dielectric film with the perovskite type crystal structure represented by ABO₃ on an electrode, film formation was carried out by changing the following film formation conditions and properly selecting the respectively optimized conditions; first film formation conditions for forming initial nuclei with the perovskite type crystal structure or formation of an initial layer on the electrode and second film formation conditions for growing a film with the perovskite type crystal structure further on the initial nuclei; in contrast with a conventional film formation method for forming a film on a conductive material in the same conditions.

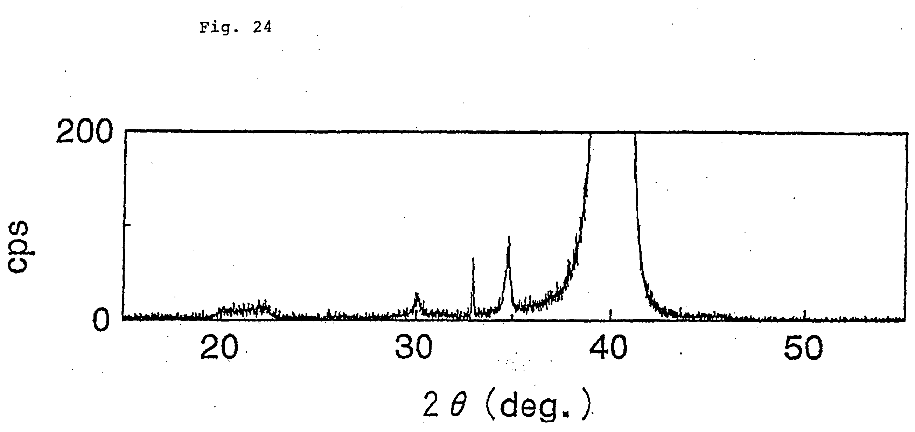

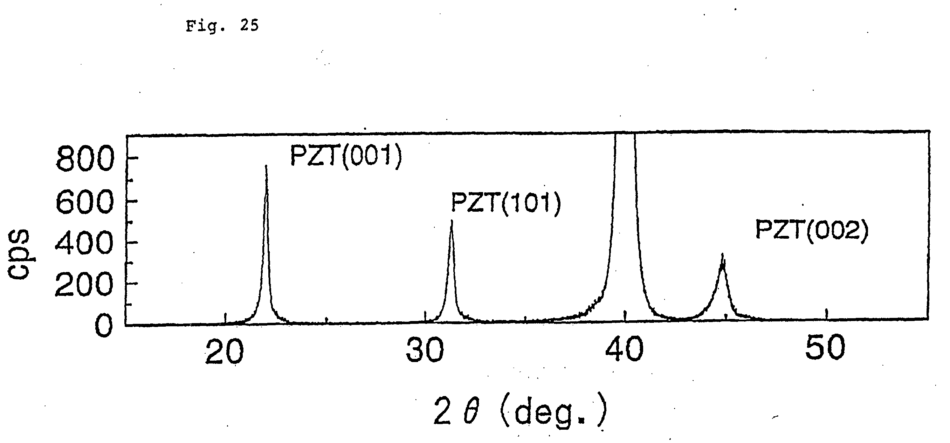

Fig. 24 is an x-ray spectrum in the case of forming a 100 nm PZT film at 500°C film formation temperature and for 600 seconds in conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂. Fig. 25 is an x-ray spectrum in the case of forming a 100 nm PZT film at 500°C film formation temperature in conditions at first of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ for 40 seconds and then in conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂ for 600 seconds. Silicon wafers employed for substrates were those produced by forming a 500 nm thick silicon oxide film on silicon wafers and then forming a 200 nm thick Pt film by a sputtering method. In comparison of Fig. 24 and Fig. 25 to each other, only the peak of Pt was observed in Fig. 24 showing that no PZT crystallization took place, whereas peaks of (100),(200) of PZT were observed in Fig. 25 showing that it was effective to carry out film formation by altering the flow rates in two stages as described above to form a perovskite type film with excellent crystallinity.

Table 1 shows the proper flow rates of Pb, Zr, and Ti raw materials separately for the initial nuclei formation time and film formation time in the case of forming Pb(Zr_{0.5}Ti_{0.5})O₃ on Pt, Ir, Ru, IrO₂, and RuO₂ at 400°C substrate temperature. In the case of carrying out film formation on Pt, as compared with the cases of film formation on Ir, Ru, IrO₂, and RuO₂, that the Pb flow rate is high at the time of the initial nuclei formation is because, as for Pt, diffusion coefficient of Pb into Pt is high and subsequently, the Pb concentration on the surface is decreased by the diffusion. Diffusion of Pb into Ir, Ru is scarce. The optimum film formation conditions are all the same after the perovskite nuclei are generated and successively the electrode surface is coated with PZT. Table 2 shows the proper flow rates of Pb, Zr, and Ti raw materials separately for the initial nuclei formation time and film formation time in the case of forming Pb(Zr_{0.5}Ti_{0.5})O₃ on Pt, Ir, Ru, IrO₂, and RuO₂ by carrying out at first nuclei formation using PTO and successively forming PZT. Also in this case, the Pb flow rate is low at the time of initial nuclei formation on Ir, Ru, IrO₂, and RuO₂. The reason for that is also because Pb is diffused much into Pt. In the case of a Pt/Ti layered structure, the Ti concentration on the surface is increased since Ti is diffused and appears on the Pt surface at the time of heating and therefore, in order to carry out nuclei formation, it is required to lower the Ti supply amount as compared with that in the case no Ti exists under Pt. By forming a Pt/TiN/Ti structure, Ti diffusion can be suppressed by TiN and the crystallinity of Pt on the TiN is provided with a structure oriented highly to (111), so that the crystallinity and orientation property of PZT can be improved and the initial nuclei generation can easily be controlled. Film formation can also be carried out on a Pt/SiO₂ structure in the same manner.

**[Table 1]**

| Conductive material | First film formation conditions (SCCM) | | | | Second film formation conditions (SCCM) | | | |
|---|---|---|---|---|---|---|---|---|
| | Gas flow rate of Pb raw material | Gas flow rate of Zr raw material | Gas flow rate of Ti raw material | Gas flow rate of NO₂ raw material | Gas flow rate of Pb raw material | Gas flow rate of Zr raw material | Gas flow rate of Ti raw material | Gas flow rate of NO₂ raw material |
| Pt | 0.25 | 0.1 | 0.15 | 3.0 | 0.2 | 0.225 | 0.25 | 3.0 |
| Ir | 0.2 | 0.15 | 0.15 | 3.0 | 0.2 | 0.225 | 0.25 | 3.0 |
| Ru | 0.2 | 0.15 | 0.15 | 3.0 | 0.2 | 0.225 | 0.25 | 3.0 |
| IrO₂ | 0.25 | 0.1 | 0.15 | 3.0 | 0.2 | 0.225 | 0.25 | 3.0 |
| RuO₂ | 0.25 | 0.1 | 0.15 | 3.0 | 0.2 | 0.225 | 0.25 | 3.0 |

**[Table 2]**

| Conductive material | First film formation conditions (SCCM) | | | | Second film formation conditions (SCCM) | | | |
|---|---|---|---|---|---|---|---|---|
| | Gas flow rate of Pb raw material | Gas flow rate of Zr raw material | Gas flow rate of Ti raw material | Gas flow rate of NO₂ raw material | Gas flow rate of Pb raw material | Gas flow rate of Zr raw mater material | Gas flow rate of Ti raw material | Gas flow rate of NO₂ raw material |
| Pt | 0.25 | 0 | 0.25 | 3.0 | 0.2 | 0.225 | 0.25 | 3.0 |
| Ir | 0.2 | 0 | 0.25 | 3.0 | 0.2 | 0.225 | 0.25 | 3.0 |
| Ru | 0.2 | 0 | 0.25 | 3.0 | 0.2 | 0.225 | 0.25 | 3.0 |
| IrO₂ | 0.25 | 0 | 0.25 | 3.0 | 0.2 | 0.225 | 0.25 | 3.0 |
| RuO₂ | 0.25 | 0 | 0.25 | 3.0 | 0.2 | 0.225 | 0.25 | 3.0 |

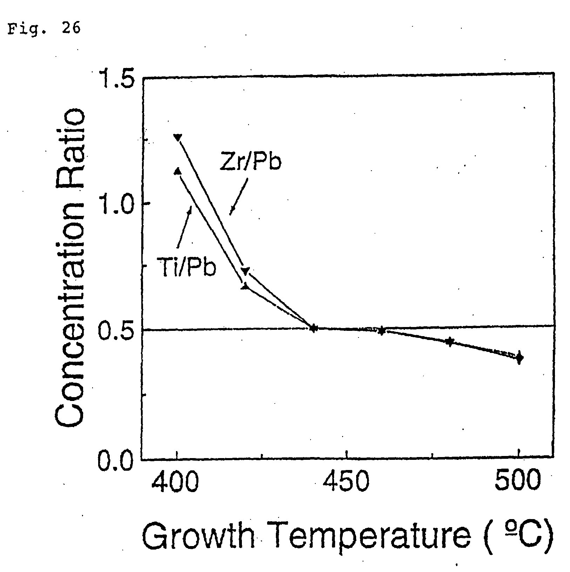

As shown above, in the case of film growth at the same temperature, it is required to control the flow rates at the time of initial perovskite nuclei formation depending on the difference of the electrodes. The gas decomposition efficiency, the adhesion coefficient, the diffusion coefficient in relation to the electrode surfaces and further the gas decomposition efficiency, the adhesion coefficient, the diffusion coefficient in relation to PZT are also changed by the film formation temperature. Fig. 26 shows the composition ratios of Ti/Pb and Zr/Pb in the case of changing only the film formation temperature in 100 nm thick PZT film formation on Pt/SiO₂ carried out in the prescribed film formation conditions: at first for 40 seconds in the conditions of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ and then further for 100 seconds in the conditions of keeping 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂. According to Fig. 26, the composition is changed following the alteration of the substrate temperature. Consequently, also in the case of altering the substrate temperature, It is required to select the optimum initial nuclei generation conditions and growth conditions.

Already shown Figs. 8 show x-ray diffraction spectra in the case of optimizing the film formation conditions for the respective stages and changing the film formation temperature.

A method of the present invention is also significantly effective to improve the characteristic deterioration at the time of making a film thin and as for this, the effects are as shown in Fig. 12 and Fig. 14.

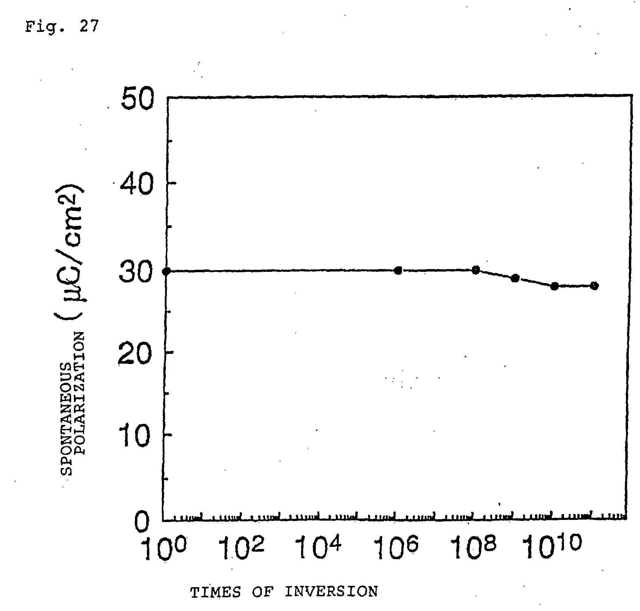

A method of the present invention is also significantly effective to improve inversion fatigue strength. It also based on the same principle as that in the case of the improvement of property deterioration at the time of making a film thin. It is known that the inversion fatigue in the interface between an electrode and a ferroelectric thin film is attributed to the pin stop effect of electric charge. Therefore, the inversion fatigue strength can be improved by heightening the perfection of the interface by lessening the transition layer in the interface. Fig. 27 shows the dependency of spontaneous polarization on the number of inversion times in the case of PZT film formation by a vapor phase growth method of the present invention. Silicon wafers employed for substrates were those produced by forming a 500 nm thick silicon oxide film on silicon wafers and then forming a 200 nm thick Pt film by a sputtering method. Film formation was carried out at 400°C substrate temperature in conditions at first of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ for 40 seconds and then in conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂ for 600 seconds. The grown film thickness was 100 nm. Spontaneous-polarization was measured by forming 200 nm thick Pt film as an upper part electrode by sputtering, separating by etching, and then measuring the polarization between the upper part and lower part electrodes by Sawyer Tower circuit. According to Fig. 27, no fatigue was observed even after inversion repeated 1011 times and the method of the present invention was found effective to improve the inversion fatigue strength.

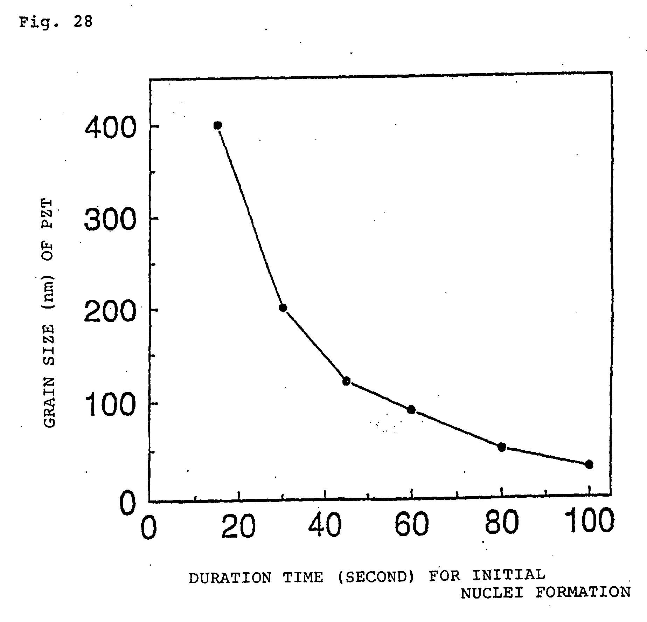

A method of the present invention is also applicable for grain size control. That is based on the following principle. When film formation is carried out in the initial nuclei formation conditions, just as shown in Fig. 4, island-like perovskite crystal nuclei are formed on the electrode. The density of the crystal nuclei is proportional to the duration time of the initial nuclei growth. Then, when the film formation is carried out by changing from the nuclei formation conditions to the film formation conditions, crystal growth takes place mainly on these crystal nuclei. Therefore, a polycrystal having the same crystalline-density as that of the nuclei initially formed on the electrode can be produced. That is, if the nuclei density (i.e. number of nuclei) on the electrode is lowered by shortening the nuclei formation duration time, the grain size finally obtained becomes large. If the nuclei density is increased by prolonging the nuclei formation time, the grain size finally obtained becomes small. Fig. 28 shows the correlation of the duration of the initial nuclei formation and the grain size of PZT in the case of changing the duration of the initial nuclei formation from 15 seconds to 100 seconds in film formation carried out at 400°C substrate temperature in conditions at first of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ for nuclei formation and then in conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂ for film formation for 600 seconds. According to Fig. 28, by changing the duration time of the initial nuclei formation, the grain size can be changed from 30 nm to 400 nm. It is difficult to grow nuclei with the distance of 30 nm or shorter. If the nuclei are formed with the distance of 400 nm or wider, amorphous film containing Pb, Ti, and Zr begins to form between the nuclei. If the grain size is too small, the electric properties are deteriorated and therefore, the grain size is preferably selected corresponding to the element size.

Next, investigation of the effect of the coating of the surface of a susceptor with a high temperature part-coating dielectric material was performed using a vapor phase growth apparatus of the present invention.

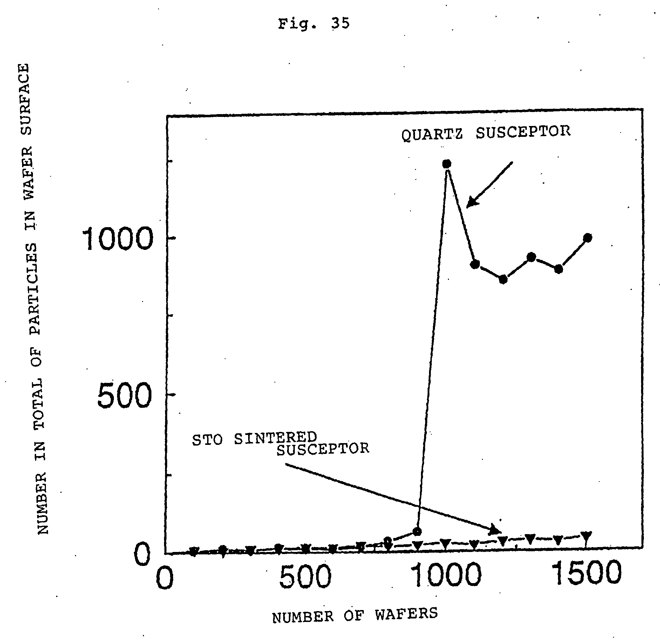

Fig. 35 shows particle generation in the case of film formation carried out at 400°C for 40 seconds substrate temperature in conditions at first of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ for nuclei formation and then in conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂ for film formation for 600 seconds. The Fig. 35 shows the correlation of the number of wafers on which films are continuously formed and the total number of particles on 6-inch wafers in comparison using a quartz susceptor and using a quartz susceptor on which a 100 µm STO was formed by sintering. Here, the inner walls of the vacuum chamber were coated with aluminum oxide and kept at 180°C.

According to Fig. 35, in the case where the susceptor surface was quartz, the number of particles was sharply increased when the number of wafers exceeds 1,000 sheets. That was attributed to parting of PZT stuck to the quartz when the number of wafers exceeds 1,000 sheets. On the other hand, in the case of forming sintered STO on quartz, the increase of particles was slight. That was attributed to that STO and quartz were firmly stuck to each other and STO and PZT were ceramics both having similar crystal systems and consequently, parting hardly took place.

Next, raw material adhesion to the inner walls of a vacuum chamber was investigated using a vapor phase growth apparatus of the present invention.

Respective plate specimens of aluminum, quartz, quartz coated with a 10 µm thick aluminum oxide thereon by sintering, stainless steel, copper, and silver were made ready and these specimens were put in a vacuum chamber kept at 180°C. When the respective plate specimens were heated to 180°C, raw material gases were continuously supplied to the vacuum chamber for 120 minutes in conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂.

As a result, copper was oxidized by NO₂ and corroded to be blacken on the surface. Though other materials were not corroded, a much amount of a white powder supposed to be the deposited organometal materials adhered to the surface of quartz, the stainless steel, and silver. Further, though not so much as that in the case of quartz or others, a white powder adhered in the same manner to the aluminum surface to make it clear that an aluminum oxide in the thickness formed by spontaneous oxidation was insufficient. In contrast with these materials, in the case of quartz coated with aluminum oxide by sintering, powder adhesion was not at all observed.

Next, investigation was performed for the effect on suppression of particle generation in the case of practically coating the inner walls of a vacuum chamber with aluminum oxide using a vapor phase growth apparatus of the present invention.

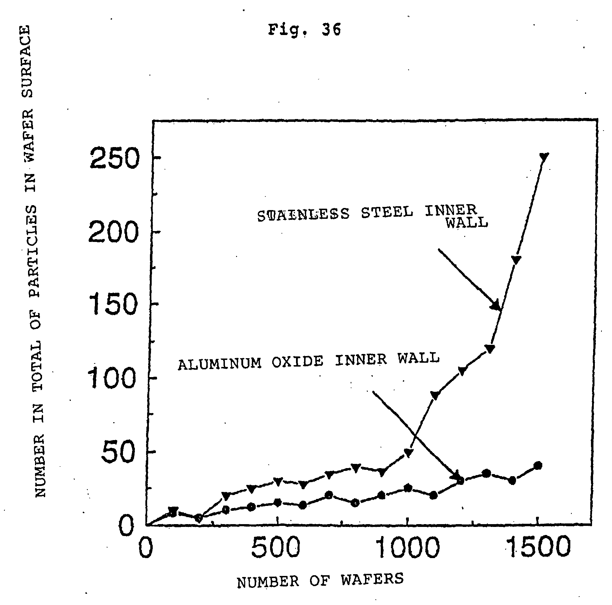

Fig. 36 shows particle generation state in the case of film formation carried out at 400°C substrate temperature in conditions at first of 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ for 40 seconds for film formation and then in conditions of 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂ for film formation for 600 seconds. The Fig. 36 shows the correlation of the number of wafers on which films are continuously formed and the total number of particles on 6-inch wafers in comparison of the case of using aluminum oxide for the inner walls of the vacuum chamber and the case of using a stainless steel.

A susceptor employed for the case was a quartz susceptor on which STO was formed by sintering and the inner wall temperature of the vacuum chamber was kept at 180°C.

According to Fig. 36, in the case of using aluminum oxide for the inner walls, the number of generated particles was less even when the number of wafers exceeds 1,000 sheets. That was attributed to that the amount of raw material gases adhering to the walls was smaller in the case of using aluminum oxide and consequently, the number of generated particles was lessened.

Such results were observed in same in the case the walls of the vacuum chamber were lined with liners of quartz or aluminum both coated with aluminum oxide on the surface.

Though an embodiment of the present invention was described above while exemplifying PZT film formation, a vapor phase growth method of the present invention is not limited to the PZT film formation methods and effective to formation of a metal oxide dielectric film whose properties can be changed by crystal orientation. The metal oxide dielectric materials for a ferroelectric or high-dielectric-constant film formable to be a film by a film formation method of the present invention include oxides having general formulas; SrBi₂Ez₂O₉ (wherein Ez denotes Nb or Ta); EpBi₂EqO₉ (wherein Ep denotes Ba or Pb and Eq denotes Nb or Ta); ExBi₄Ti₄O₁₅ (wherein Ex denotes Sr, Ba or Pb); Ey₂Bi₄Ti₅O₁₈ (wherein Ey denotes Sr, Ba or Pb); Pb(Zr₁₋ₓTiₓ)O₃; (Pb_{1-y}La_{y})(Zr₁₋ₓTiₓ)O₃; Bi₄Ti₃O₁₂; SrTiO₃, and (Ba₁₋ₓSrₓ)TiO₃, and the metal oxide dielectric materials are not at all restricted to these materials.

Practical examples of the foregoing ferroelectric or high-dielectric-constant metal oxide films are PTO (lead titanate: PbTiO₃), STO (strontium titanate: SrTiO₃), BTO (barium titanate: BrTiO₃), PLZT {(Pb, La)(Zr, Ti)O₃}, PNbZT {(Pb, Nb)(Zr, Ti)O₃}, SBT (SrBi₂TaO₉), Pb(Zr, Ti)O₃, (Ba, Sr)TiO₃, and the likes.

In an example of the foregoing metal oxide film, especially a dielectric film with the perovskite type crystal structure represented by ABO₃ can be formed in two steps with different film formation conditions from each other.

Further, in these embodiments, though the flow rate of each raw material gas was controlled by a mass flow controller, it was confirmed that a method of the present invention was effective to a method in which the pressure of a film formation chamber was controlled by further using partial pressure measuring means such as a molecular weight measuring apparatus and atomic absorption spectroscopy in the case of employing a raw material supply system equipped with a liquid supply type flow rate controlling apparatus and an evaporator.

Further, a vapor phase growth apparatus of the present invention can be applicable to any purpose as long as metal oxide dielectric materials such as those described above are to be formed on a substrate. The substrate is in general a semiconductor substrate and includes a semiconductor substrate having element thereon. An apparatus of the present invention can be applicable for formation of, for example, capacitor films such as ferroelectric capacitor film and high-dielectric-constant capacitor films or memories and the likes in which a ferroelectric film and a double layer structure of a silicon oxide film and a ferroelectric film known as MFS (metal ferroelectrics silicon) and MOFSMFS (metal oxide ferroelectrics silicon), and the likes.

Especially, it is most preferable to employ the apparatus for the formation of capacitor films and the capacitor electrode to carry out vapor phase growth of a metal oxide dielectric film thereon is not specifically limited but, for example, the materials usable for the electrode are Pt, Ir, Ru, IrO₂, RuO₂, TiN, WN and the likes.

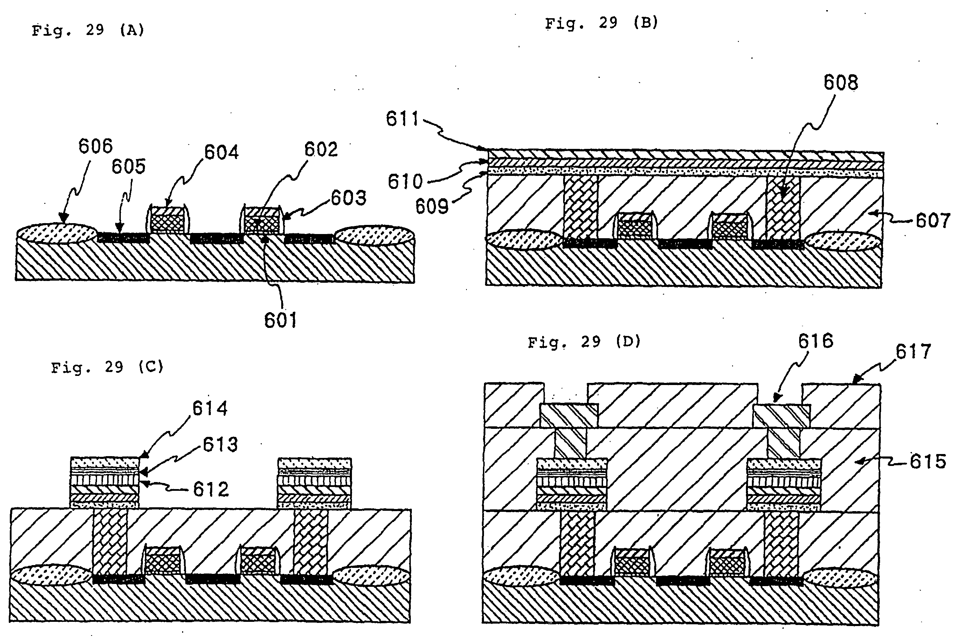

A method for fabricating a memory cell relevant to the first embodiment of the present invention is illustrated in Figs. 29. At first, an oxide film was formed on a silicon substrate by wet oxidation. After that, n-type and p-type wells were formed by ion-implantation with impurities of boron, phosphorus or the like. Then, gates and diffusion layers were formed in the following manner. At first, gate oxide films 601 were formed by wet oxidation and then polysilicon 602 was formed in film state and then etching was carried out to give gates. After a silicon oxide film was formed on the resultant polysilicon layers, etching was carried out to form side wall oxidation films 603. Next, n-type and p-type diffusion layers were formed by ion implantation with impurities of boron, arsenic or the like. Further, after a Ti film was formed on the resultant layers and reacted with silicon, the unreacted Ti was removed by etching to form Ti silicide on the gates 604 and the diffusion layers 605. Through the foregoing process, as shown in Fig. 29(A), n-type and p-type MOS type transistors isolated by the oxidized film 606 for isolated were formed on a silicon substrate.

Next, contacts and a lower part electrode were formed as illustrated in Fig. 29(B). At first, after a silicon oxide film or a silicon oxide film (BPSG) doped with impurities such as boron was formed as a first interlayer insulation film 607, leveling was carried out by a CMP method. Following to that, after contact holes were opened by etching, the respective n-type and p-type diffusion layers were implanted with impurities and then subjected to heating at 750°C for 10 seconds. After that, Ti and TiN were formed in films as barrier metals. After tungsten layer was formed further thereon by a CVD method, plugs 608 of tungsten were formed by CMP. The plugs of tungsten might be formed by etching back after CVD of tungsten. Further thereon, as a capacitor lower part electrode layer, a Ti film 609 and a TiN film 610 were successively formed by sputtering and a 100 nm thick Pt film 611 was formed thereon.

Next, a ferroelectric capacitor was formed as illustrated in Fig. 29(C). PZT of 100 nm thickness was formed by employing a method of the present invention. Lead bis(dipivaloylmethanate) Pb(DPM)₂, titanium tetra(isopropoxide) Ti(OiPr)₄, and zirconium tetra(tert-butoxide) Zr(OtBu)₄ were used as raw materials and NO₂ was used as an oxidizing agent. A metal oxide dielectric film of PZT 612 was obtained by film formation in conditions of at 400°C of the substrate temperature and at first 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ for 40 seconds and then 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂ for 600 seconds. The total pressure of the gases in the vacuum chamber during the film growth at that time was controlled to be 5 × 10⁻³ Torr. The thickness of the grown film was 100 nm. Then, IrO₂ 613 and Ir 614 were formed in films by a sputtering method to form a capacitor upper part electrode layer. Thereafter, the capacitor upper part electrode layer, the metal oxide dielectric film, and the capacitor lower part electrode layer were patterned to form isolated PZT capacitors by dry etching.

A capacitor upper part electrode was formed thereon as illustrate in Fig. 29(D). After a silicon oxide layer was formed by a plasma CVD method as a second interlayer insulation film 615, capacitor upper part contacts and plate wire contacts were opened by etching. After WSi, TiN, AlCu, and TiN were formed in films in this order by sputtering, they were processed by etching to give a second metal wirings 616. After a silicon oxide film and a SiON film were formed thereon as passivation film 617, wiring pad parts were opened and electric properties were evaluated.

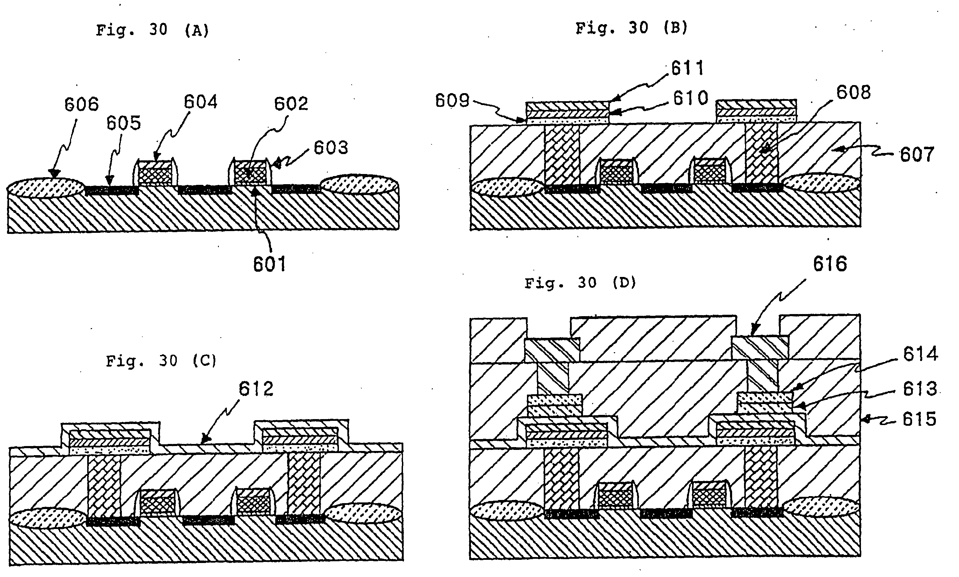

Though, with reference to Figs. 29, description was made for the method in which isolation of capacitors were performed by dry etching after formation of the capacitor lower part electrode, the PZT film, and the IrO₂/Ir capacitor upper part electrode. However, as illustrated in Figs. 30, the method may be carried out in the following order: at first the capacitor lower part electrodes, that is, Pt/TiN/Ti, are isolated by dry etching and then the PZT film is formed, the IrO₂/Ir capacitor upper part electrode layer is formed, and after that the upper part electrodes are isolated. By this method, the film required to be dry etched is thin film. Owing to this, a finer pattern can be formed. Further, since the side faces of PZT are not exposed to plasma, introduction of defects in the PZT film can be avoided. The electric properties of the capacitors fabricated by the methods illustrated by Figs. 29 and Figs. 30 will be described below.

5,000 of PZT capacitors with 1 µm square were connected in parallel and the properties were measured. As a result, 10 µC/cm² or higher value of the difference of the inversion and non-inversion electric charge was obtained to show excellent dielectric property. The fatigue property and the retention property were also excellent. Further, by evaluation of the properties in transistors of 0.26 µm gate length, variation of threshold voltage values (Vt) of both p-type and n-type was found 10% or lower in the whole surface of a wafer and found excellent. Further, by measurement of the resistance of the capacitor lower part contacts of 0.4 µm square by a contact chain method, it was found that the resistance per single contact was 10 Ωcm or lower and excellent.

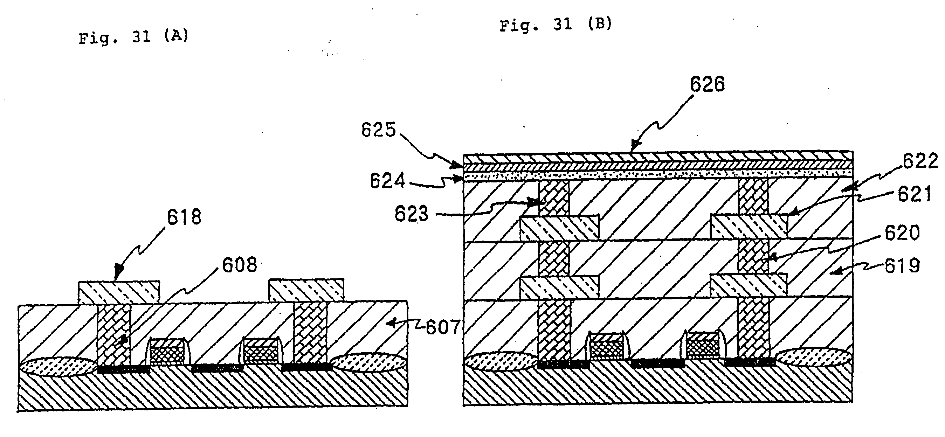

Next, a method for fabricating memory cells relevant to the second embodiment of the present invention is illustrated in Figs. 31. Memory cells were fabricated in the same manner as the first embodiment up to the step forming tungsten plugs in the process. Further, Ti, TiN films were formed thereon. An AlCu film was formed by a sputtering method and first aluminum wirings 618 were formed by a dry etching method. By the above described process, the first aluminum wiring was formed on n-type and p-type MOS transistors as illustrated in Fig. 31(A).

Then, via holes and second aluminum wirings were formed as illustrated in Fig. 31(B). At first, after a silicon oxide film or a silicon oxide film (BPSG) doped with impurities such as boron was formed as a second interlayer insulation film 619, leveling was carried out by a CMP method. Following to that, after via holes were opened by etching, Ti and TiN were formed in films as barrier metals. After tungsten was formed in a film further thereon by a CVD method, plugs 620 of tungsten were formed by CMP. The plugs of tungsten might be formed by etching back after CVD of tungsten. Further thereon, Ti and TiN were formed by a sputtering method and second aluminum wirings 621 were formed by a dry etching method. Then, as a third interlayer insulation film 622, a silicon oxide film or a silicon oxide film (BPSG) doped with impurities such as boron was formed, and leveling was carried out by a CMP method. Next, via holes were opened by etching, Ti film and TiN film were formed as barrier metals. After tungsten film was formed further thereon by a CVD method, plugs 623 of tungsten were formed by CMP. The plugs of tungsten might be formed by etching back after CVD of tungsten. A desired number of wiring layers might be formed by repeating these aluminum wiring, interlayer film formation, and via hole formation. On the final tungsten plugs, a Ti film 624 and a TiN film 625 were successively formed by sputtering and a 100 nm thick Pt film 626 was formed thereon to give lower part capacitor electrodes.

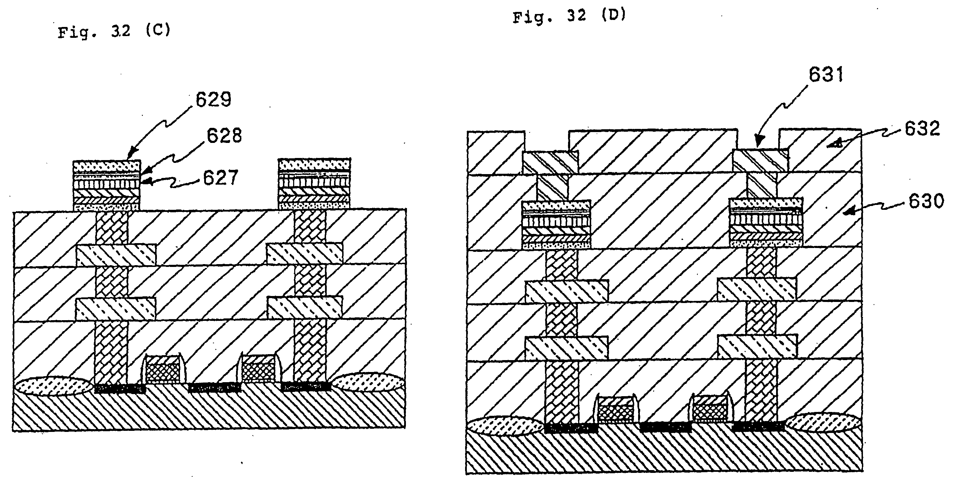

Next, a ferroelectric capacitor was formed as illustrated in Fig. 32(C). PZT of 100 nm thickness was formed by employing a method of the present invention. Lead bis(dipivaloylmethanate) Pb(DPM)₂, titanium tetra(isopropoxide) Ti(OiPr)₄, and zirconium tetra(tert-butoxide) Zr(OtBu)₄ were used as raw materials and NO₂ was used as an oxidizing agent. A metal oxide dielectric film of PZT 627 was obtained by film formation in conditions of at 400°C of the substrate temperature and at first 0.2 SCCM flow rate of Pb(DPM)₂, 0.05 SCCM flow rate of Zr(OtBu)₄, 0.25 SCCM flow rate of Ti(OiPr)₄, and 3.0 SCCM flow rate of NO₂ for 40 seconds and then 0.25 SCCM flow rate of Pb(DPM)₂, 0.225 SCCM flow rate of Zr(OtBu)₄, 0.2 SCCM flow rate of Ti(OiPr)₄, and 3.0 SCCM flow rate of NO₂ for 600 seconds. The total pressure of the gases in the vacuum chamber during the film growth at that time was controlled to be 5 × 10⁻³ Torr. The thickness of the grown film was 100 nm. After IrO₂ film 628 and Ir film 629 were formed by a sputtering method to form a capacitor upper part electrode layer, the capacitor upper part electrode layer, the metal oxide dielectric film, and the capacitor lower part electrode layer were patterned to form isolated PZT capacitors by dry etching.

A capacitor upper part electrode was formed thereon as illustrate in Fig. 32(D). After a silicon oxide film was formed by a plasma CVD method as a fourth interlayer insulation film 630, capacitor upper part contacts and plate wiring contact holes were opened by etching. After each film of WSi, TiN, AlCu, and TiN was formed in this order by sputtering, they were processed by etching to give third metal wirings 631. After a silicon oxide film and a SiON film were formed thereon as a passivation film 632, wiring pad parts were opened and electric properties were evaluated.

Even in the case where there is an aluminum wiring in the lower part, as same in the case as illustrated in Figs. 30, it may be allowed to carry out in the following order: at first the capacitor lower part electrodes, that is, Pt/TiN/Ti, are isolated by dry etching and then the PZT film is formed, the IrO₂/Ir capacitor upper part electrode layer is formed, and after that, the upper part electrodes are isolated. By this method, the film required to be dry etched is thin film. Owing to this, a finer pattern can be formed. Further, since the side faces of PZT are not exposed to plasma, introduction of defects into the PZT film can be avoided.

The electric properties of the memory cells fabricated by this second fabrication method were evaluated in the same manner as used for the memory cells fabricated by the first fabrication method.

As a result, 10 µC/cm² or higher value of the difference of the inversion and non-inversion electric charge was obtained to show excellent dielectric property. The fatigue property and the retention property were also excellent. Further, by evaluation of the properties in transistors of 0.26 µm gate length, variation of threshold voltage values (Vt) of both p-type and n-type was found 10% or lower in the whole surface of a wafer and found excellent. Further, by measurement of the resistance of the capacitor lower part contacts of 0.4 µm square by a contact chain, it was found that the resistance per single contact was 10 Ωcm or less and excellent.

Though in both cases of the first and the second embodiments relevant to the memory cells, description was given using tungsten for the contacts, also in the case of using polysilicon for the contacts, the ferroelectric capacitor property, the transistor property, and the contact resistance were all excellent as well. Further, in the examples, although description was given using Pt for the lower part electrodes, it was also confirmed that in the case of using Ir, IrO₂, IrO₂/Ir, Ru, RuO₂, TiN, or WN, the ferroelectric capacitor property, the transistor property, and the contact resistance were all excellent as well.

Though an example using PZT for ferroelectric capacitor formation was described, also in the case of forming BaSrTiO₃ as high-dielectric-constant capacitors using Ba(DPM)₂, Sr(DPM)₂, Ti(i-OC₃H₇)₄, and the likes, the capacitor property, the transistor property, and the contact resistance were found all excellent completely same as those of the example.

### INDUSTRIAL APPLICABILITY

As described above, by the present invention, a ferroelectric film and a high-dielectric-constant film with controlled orientation property can be formed at a low temperature. In addition, even if a film is made thin, the characteristics of the film are scarcely deteriorated and a film with low inversion fatigue and excellent crystallinity can be obtained. By employing the present method, ferroelectric capacitors or high-dielectric-constant capacitors can be fabricated on electrodes formed on plugs such as tungsten and polysilicon without deteriorating the plugs and wiring and transistors in the lower layers to enable significant miniaturization of the capacitor surface area and to remarkably heighten the integration degree.

Further, by an apparatus of the present invention, an excellent metal oxide dielectric film can be formed while suppressing dust adhesion to a wafer at the time of film formation, so that capacitors with miniaturized surface area and free of defects are made possible to be fabricated using a ferroelectric material and a high-dielectric-constant material. Consequently, a semiconductor device with remarkably heightened integration degree can be fabricated at high production yield.

## Claims

1. A vapor phase growth method of a metal oxide dielectric film on a substrate using organometal gases, comprising: a step of carrying out film formation by introducing the organometal gases and an oxidizing gas into a vacuum chamber through separate introduction inlets while heating the substrate set in the vacuum chamber and keeping the total pressure of the vacuum chamber at 1 × 10⁻² Torr or lower.

2. A vapor phase growth method of a metal oxide dielectric film according to claim 1, wherein the substrate temperature is at 450°C or lower during the film formation.

3. A vapor phase growth method of a metal oxide dielectric film according to claim 1 or 2, wherein the total pressure of the vacuum chamber is at 1 × 10⁻⁴ Torr or higher and 1 × 10⁻² Torr or lower.

4. A vapor phase growth method of a metal oxide dielectric film according to any one of claims 1 to 3, wherein the oxidizing gas comprises nitrogen dioxide gas.

5. A vapor phase growth method of a metal oxide dielectric film according to any one of claims 1 to 4, wherein the film formation is carried out by controlling the gas supply conditions for the organometal gases and/or the oxidizing gas to be self-controlling gas supply conditions as to obtain the metal oxide dielectric film having a prescribed composition and crystal structure.

6. A vapor phase growth method of a metal oxide dielectric film according to the claim 5, wherein the flow rates of organometal gases and the oxidizing gas are directly controlled without using a carrier gas to introduce the organometal gases and the oxidizing gas into the vacuum chamber.

7. A vapor phase growth method of a metal oxide dielectric film according to any one of claims 1 to 6, wherein the metal oxide dielectric film is a PZT film or a BST film.

8. A vapor phase growth method of a metal oxide dielectric film according to any one of claims 1 to 7, wherein the substrate has capacitor electrodes formed thereon which comprises at least any one of metals or metal oxides of Pt, Ir, Ru, IrO₂, RuO₂, TiN, or WN and the metal oxide dielectric film is formed on the substrate in vapor phase.

9. A vapor phase growth method of a metal oxide dielectric film according to any one of claims 1 to 8, wherein the substrate has an Al wiring formed thereon and the metal oxide dielectric film is formed on the substrate in vapor phase.

10. A vapor phase growth method of a metal oxide dielectric film according to any one of claims 1 to 9, wherein the temperature of the inner walls of the vacuum chamber is equal to or higher than a temperature to allow the organometal gases to have a sufficiently high vapor pressure and equal to or lower than an organometal gas decomposition temperature.

11. A method for fabricating a semiconductor device, comprising: a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation film and burying a metal plug in the contact, a step of forming a capacitor lower part electrode layer on the whole surface of the first interlayer insulation film having the metal plug, a step of forming a metal oxide dielectric film on the whole surface of the capacitor lower part electrode layer using organometal gases and an oxidizing gas at 1 × 10⁻⁴ Torr or higher to 1 × 10⁻² Torr or lower of the total pressure while keeping the temperature of the semiconductor substrate at 450°C or lower, a step of forming a capacitor upper part electrode layer on the whole surface of the metal oxide dielectric film, and a step of patterning the lower part electrode layer, the metal oxide dielectric film, and the capacitor upper part electrode layer to obtain a capacitor with a three-layered laminated structure.

12. A method for fabricating a semiconductor device, comprising: a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation film and burying a metal plug in the contact, a step of forming a capacitor lower part electrode layer on the whole surface of the first interlayer insulation film having the metal plug, a step of forming a capacitor lower part electrode on the metal plug by patterning the capacitor lower part electrode, a step of forming a metal oxide dielectric film on the patterned capacitor lower part electrode and on the whole surface of the first interlayer insulation film using organometal gases and an oxidizing gas at 1 × 10⁻⁴ Torr or higher to 1 ×10⁻² Torr or lower of the total pressure while keeping the temperature of the semiconductor substrate at 450°C or lower, a step of forming a capacitor upper part electrode layer on the whole surface of the metal oxide dielectric film, and a step of patterning the capacitor upper part electrode layer to obtain a capacitor with a three-layered laminated structure of the capacitor lower part electrode, the metal oxide dielectric film, and the capacitor upper part electrode.

13. A method for fabricating a semiconductor device, comprising: a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation film and burying a metal plug in the contact, a step of forming an aluminum wiring electrically connected to the metal plug on the first interlayer insulation film, a step of forming a second interlayer insulation film on the aluminum wiring, a step of forming electric conduction by opening a contact reaching the aluminum wiring in the second interlayer insulation film and burying a metal plug, a step of forming a capacitor lower part electrode layer on the whole surface of the second interlayer insulation film including the metal plug, a step of forming a metal oxide dielectric film on the whole surface of the capacitor lower part electrode layer using organometal gases and an oxidizing gas at 1 × 10⁻⁴ Torr or higher to 1 × 10⁻² Torr or lower of the total pressure while keeping the temperature of the semiconductor substrate at 450°C or lower, a step of forming a capacitor upper part electrode layer on the whole surface of the metal oxide dielectric film, and a step of patterning the capacitor lower part electrode layer, the metal oxide dielectric film, and the capacitor upper part electrode layer to obtain a capacitor with a three-layered laminated structure.

14. A method for fabricating a semiconductor device according to claim 13, wherein aluminum wiring to be formed in the lower layer of the capacitor is made multilayered by repeating, at least one time before the capacitor lower part electrode layer is formed, a step of forming an aluminum wiring electrically conducting to the finally formed metal plug, a step of forming an interlayer insulation film on the aluminum wiring, and a step of forming electric conduction by opening a contact reaching the aluminum wiring in the interlayer insulation film and burying a metal plug in the contact.

15. A vapor phase growth method for carrying out film formation of a metal oxide dielectric film with a perovskite type crystal structure represented by ABO₃ on a conductive material using organometal gases, comprising steps of: carrying out initial nuclei formation of the perovskite type crystal structure on the conductive material using all of the organometal gases to be the raw materials of the metal oxide dielectric film under first film formation conditions, and carrying out film formation of the perovskite type crystal structure further on the initial nuclei under second film formation conditions.

16. A vapor phase growth method for carrying out film formation of a metal oxide dielectric film with a perovskite type crystal structure represented by ABO₃ on a conductive material using organometal gases, comprising steps of: carrying out initial layer formation of the perovskite type crystal structure on the conductive material using all of the organometal gases to be the raw materials of the metal oxide dielectric film under first film formation conditions and carrying out film formation of the perovskite type crystal structure further on the initial layer under second film formation conditions.

17. A vapor phase growth method for carrying out film formation of a metal oxide dielectric film with a perovskite type crystal structure represented by ABO₃ on a conductive material using organometal gases, comprising steps of: carrying out initial nuclei formation of the perovskite type crystal structure on the conductive material using only a part of the organometal gases to be the raw materials of the metal oxide dielectric film under first film formation conditions and carrying out film formation of the perovskite type crystal structure further on the initial nuclei under second film formation conditions.

18. A vapor phase growth method for carrying out film formation of a metal oxide dielectric film according to any one of claims 15 to 17, wherein the second film formation conditions are so set as to carry out film formation using raw material gas supply in good self-controlling conditions, and the raw material of the A element is supplied in a higher quantity in the first film formation conditions than that in the second film formation conditions.

19. A vapor phase growth method for carrying out film formation of a metal oxide dielectric film according to any one of claims 15 to 18, wherein the supply amount of Zr in the B element, in the case where the B element includes both Zr and Ti, is decreased relatively to that of Ti in the first film formation conditions as compared with in the second film formation conditions.

20. A vapor phase growth method according to claim 17, wherein the first film formation conditions are so controlled as to supply no Zr raw material gas in film formation in the case Zr and other elements are contained as the B element.

21. A vapor phase growth method for carrying out film formation of a metal oxide dielectric film according to claim 15 or 17, wherein the film formation is carried out while controlling the crystal grain size by controlling the duration time of the initial nuclei formation in the first film formation conditions.

22. A vapor phase growth method for carrying out film formation of a metal oxide dielectric film according to any one of claims 15 to 21, wherein the total pressure of the raw material gases including the organometal gases at the time of film formation is kept at 1 × 10⁻² Torr or lower.

23. A vapor phase growth method for carrying out film formation of a metal oxide dielectric film according to claim 22, wherein the film formation temperature is kept at 450°C or lower.

24. A vapor phase growth method of a metal oxide dielectric film according to any one of claims 15 to 17, wherein the metal oxide dielectric film is a PZT film or a BST film.

25. A vapor phase growth method of a metal oxide dielectric film according to any one of claims 15 to 24, wherein the conductive material is a capacitor electrode comprising at least any one of metals and metal oxides of Pt, Ir, Ru, IrO₂, RuO₂, TiN, and WN.

26. A vapor phase growth method of a metal oxide dielectric film according to any one of claims 15 to 24, wherein the conductive material has a three-layered structure of Pt/TiN/Ti.

27. A vapor phase growth method of a metal oxide dielectric film according to any one of claims 15 to 24, wherein the conductive material has a four-layered structure of Pt/TiN/Ti/W.

28. A method for fabricating a semiconductor device, comprising: a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation. film and burying a metal plug in the contact, a step of forming a capacitor lower part electrode layer on the whole surface of the first interlayer insulation film having the metal plug, a step of forming initial nuclei or an initial layer of a metal oxide dielectric film having the perovskite type crystal structure on the whole surface of the capacitor lower part electrode layer using organometal gases under the first film formation conditions and further forming the metal oxide dielectric film having the perovskite type crystal structure on the initial nuclei or the initial layer under the second film formation conditions, a step of forming a capacitor upper part electrode layer on the whole surface of the metal oxide dielectric film, and a step of patterning the capacitor lower part electrode layer, the metal oxide dielectric film, and the capacitor upper part electrode layer to obtain a capacitor with a three-layered laminated structure.

29. A method for fabricating a semiconductor device comprising: a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation film and burying a metal plug in the contact, a step of forming a capacitor lower part electrode layer on the whole surface of the. first interlayer insulation film having the metal plug, a step of forming a capacitor lower part electrode on the metal plug by patterning the capacitor lower part electrode layer, a step of forming initial nuclei or an initial layer of a metal oxide dielectric film having the perovskite type crystal structure on the whole surface of the patterned capacitor lower part electrode and the first interlayer insulation film layer using organometal gases under the first film formation conditions and further forming the metal oxide dielectric film having the perovskite type crystal structure on the initial nuclei or the initial layer under the second film formation conditions, a step of forming a capacitor upper part electrode layer on the whole surface of the metal oxide dielectric film, and a step of patterning the capacitor upper part electrode layer to obtain a capacitor with a three-layered laminated structure of the capacitor lower part electrode, the metal oxide dielectric film, and the capacitor upper part electrode.

30. A method for fabricating a semiconductor device, comprising a step of forming a MOS-type transistor on a semiconductor substrate, a step of forming a first interlayer insulation film on the transistor, a step of forming electric conduction by opening a contact reaching the diffusion layer of the MOS-type transistor in the first interlayer insulation film and burying a metal plug in the contact, a step of forming an aluminum wiring on the first interlayer insulation film to electrically connecting the aluminum wire with the metal plug, a step of forming a second interlayer insulation film on the aluminum wiring, a step of forming electric conduction by opening a contact reaching the aluminum wiring in the second interlayer insulation film and burying a metal plug in the contact, a step of forming a capacitor lower part electrode layer on the whole surface of the second interlayer insulation film having the metal plug, a step of forming initial nuclei or an initial layer of a metal oxide dielectric film having the perovskite type crystal structure on the whole surface of the whole surface of the capacitor lower part electrode layer using organometal gases under the first film formation conditions and further forming the metal oxide dielectric film having the perovskite type crystal structure on the initial nuclei or the initial layer under the second film formation conditions, a step of forming a capacitor upper part electrode layer on the whole surface of the metal oxide dielectric film, and a step of patterning the capacitor lower part electrode layer, the metal oxide dielectric film, and the capacitor upper part electrode layer to obtain a capacitor with a three-layered laminated structure.

31. A method for fabricating a semiconductor device according to claim 30, wherein aluminum wiring to be formed in the lower layer of the capacitor is made multilayered by repeating, at least one time before the capacitor lower part electrode layer is formed, a step of forming an aluminum wiring electrically conducting to the finally formed metal plug, a step of forming an interlayer insulation film on the aluminum wiring, and a step of forming electric conduction by opening a contact reaching the aluminum wiring in the interlayer insulation film and burying a metal plug in the contact.

32. An apparatus to be employed for vapor phase growth of a metal oxide dielectric material on a substrate in a vacuum chamber using organometal gases and an oxidizing gas as raw material gases by brining these gases into contact with one another, comprising: an apparatus part to be brought into contact with raw material gases and to be heated to the temperature equal to or higher than the decomposition temperature of the raw material gases; at least the surface of the apparatus part to which the raw material gases contact being made of a metal oxide dielectric material (hereafter referred to as a high temperature part-coating dielectric material) same or not same as the metal oxide dielectric material to be grown.

33. An apparatus for vapor phase growth according to claim 32, wherein the high temperature part-coating dielectric material is a material selected from the group consisting of SrTiO₃, BaTiO₃, PbTiO₃, Pb(Zr, Ti)O₃, (Ba, Sr)TiO₃, (Pb, La)(Zr, Ti)O₃, (Pb, Nb)(Zr, Ti)O₃, and SrBi₂Ta₂O₉.

34. An apparatus for vapor phase growth according to claim 32 or 33, wherein the apparatus part to be brought into contact with raw material gases and heated to the temperature equal to or higher than the decomposition temperature of the raw material gases comprises a susceptor for supporting a substrate.

35. A vapor phase growth apparatus to be employed for vapor phase growth of a metal oxide dielectric material on a substrate in a vacuum chamber using organometal gases and an oxidizing gas as raw material gases by bringing the gases into contact with one another on the substrate, comprising: an apparatus part to be brought into contact with the raw material gases and to be heated to the temperature equal to or lower than the decomposition temperature of the raw material gases; at least the surface of the apparatus part to which the raw material gases contact being made of aluminum oxide.

36. A vapor phase growth apparatus according to claim 35, wherein the apparatus part to be to be brought into contact with the raw material gases and heated to the temperature equal to or lower than the decomposition temperature of the raw material gases is the inner wall of a vacuum chamber to carry out vapor phase growth of a metal oxide dielectric material therein.

37. A vapor phase growth apparatus according to claim 35, wherein the apparatus part to be to be brought into contact with the raw material gases and heated to the temperature equal to or lower than the decomposition temperature of the raw material gases comprises a liner installed in the inner wall of a vacuum chamber to carry out vapor phase growth of a metal oxide dielectric material therein.

38. A vapor phase growth apparatus according to any one of claims 32 to 37, wherein the vapor phase growth apparatus comprises wall heating means to heat the walls of the vacuum chamber and is to set at a temperature equal to or higher than that allowing the organometal gases to have sufficiently high vapor pressure and at a temperature equal to or lower than the decomposition temperature of each organometal gas.

39. A vapor phase growth apparatus according to any one of claims 32 to 38, wherein the vapor phase growth apparatus comprises respectively independent pipes as pipes for introducing respective raw material gases into the vacuum chamber.

40. A vapor phase growth apparatus according to any one of claims 32 to 39, wherein the vapor phase growth apparatus comprises separately the vacuum chamber and a heater chamber equipped with a heater for heating a substrate, and the vacuum chamber and the heater chamber are independently provided with pumps for exhaust gases.

41. A vapor phase growth apparatus according to claim 40, wherein the vacuum chamber and the heater chamber are communicated with each other through holes for pins to exchange substrates mounted on a susceptor and in the state the substrates are mounted on the susceptor, the holes are closed by the substrates to separate the vacuum chamber and the heater chamber.

42. A vapor phase growth apparatus according to any one of claims 32 to 41, further comprising: a main exhaust line connected to a pump and a sub exhaust line equipped with a water cooling trap between the vacuum chamber and a pump as exhaust lines for evacuate the vacuum chamber.

43. A vapor phase growth apparatus according to any one of claims 32 to 42, wherein the vacuum chamber is made of aluminum.

44. A vapor phase growth apparatus to be employed for vapor phase growth of a metal oxide dielectric material on a substrate in a vacuum chamber using organometal gases and an oxidizing gas as raw material gases by bringing these gases into contact with one another on the substrate, comprising: a valve capable of opening at the time when a substrate is put in and taken out between the forgoing vacuum chamber and an exchange chamber and with a movable shielding plate in the vacuum chamber side of the valve for preventing adhesion of raw material gases to the valve.

45. A vapor phase growth apparatus according to claim 44, wherein the movable shielding plate is set at a temperature equal to or higher than that allowing the organometal gases to have sufficiently high vapor pressure and at a temperature equal to or lower than the decomposition temperature of each organometal gas.

46. A vapor phase growth apparatus according to any one of claims 32 to 45, wherein the vapor phase growth apparatus is used for formation of a capacitor film of a semiconductor device.
